# EUROPEAN PATENT APPLICATION

(11) **EP 4 585 874 A1**
(43) Date of publication of application: **16.07.2025**
(21) Application number: 23885986.2
(22) Date of filing: 31.08.2023
(51) Int. Cl.: F25D 31/00, F25B 21/02, B67D 1/08

(54) **COOLING DEVICE AND CONTROL METHOD THEREFOR**

(30) Priority: 04.11.2022 KR 20220146029
(71) Applicant: Coway Co., Ltd., Gongju-si, Chungcheongnam-do 32508 (KR)
(72) Inventor: KIM, Gyeong Jong, Gongju-si, Chungcheongnam-do 32508 (KR); KIM, Jae Man, Gongju-si, Chungcheongnam-do 32508 (KR); LEE, Hyun Woo, Gongju-si, Chungcheongnam-do 32508 (KR); LEE, Gyeong Min, Gongju-si, Chungcheongnam-do 32508 (KR); LEE, Kwon Jae, Gongju-si, Chungcheongnam-do 32508 (KR); KIM, Chung Rae, Gongju-si, Chungcheongnam-do 32508 (KR); CHO, Jae Wook, Gongju-si, Chungcheongnam-do 32508 (KR); SON, Chang Min, Gongju-si, Chungcheongnam-do 32508 (KR)
(74) Representative: Vossius & Partner Patentanwälte Rechtsanwälte mbB
(86) International application number: PCT/KR2023/013026
(87) International publication number: WO 2024/096289

(57) **Abstract**

Disclosed are a cooling device and a control method therefor. The cooling device according to one aspect of the present invention comprises: a main tank fluidly connected to the outside thereof to receive a fluid, store the received fluid, and deliver the stored fluid to the outside; a heat exchanger positioned adjacent to the main tank to cool the fluid that has been delivered; and a sub-tank which is fluidly connected to the main tank to receive the fluid that has been delivered to the main tank and which is coupled to the heat exchanger to cool the delivered fluid, wherein the fluid introduced into the main tank may be cooled by the heat exchanger while passing through the sub-tank and then flow back to the main tank.

## Description

### TECHNICAL FIELD

The present invention relates to a cooling device and a control method therefor, and more particularly, to a cooling device capable of improving energy efficiency and cooling efficiency and a control method therefor.

### BACKGROUND

The water purifier collectively refers to any apparatus that may receive raw water and process it in a state desired by the user, and then provide it to the user. The water purifier may filter raw water using various types of filters and provide it to the user. For example, the water purifier may filter raw water to be suitable for drinking and provide it to the user.

In recent years, water purifiers that can perform additional functions rather than just providing purified water by filtering raw water are gaining popularity as living standards and user needs are diversified. For example, recently, water purifiers that can provide hot water, cold water, and even ice to users have been marketed and sold popularly.

Typically, a water purifier for dispensing cold water is equipped with a tank for receiving purified water and a component for cooling the purified water accommodated in the tank. A water purifier of the above type may be referred to as a tank-type water purifier. Tank-type water purifiers are widely used because they can dispense a large amount of cold water at once.

In the case of components for cooling the purified water accommodated in the tank, it is common for them to be operated by receiving electric power. In particular, to simultaneously achieve miniaturization of the water purifier and cooling effect of purified water, the above components are often equipped with thermoelectric elements. As is known, thermoelectric elements are configured to perform cooling by utilizing the Peltier effect.

In the case of water purifiers currently on the market, a thermoelectric element is coupled to the tank itself that accommodates purified water to cool the purified water. Accordingly, when the thermoelectric element and the fan connected thereto stop, the temperature of the cold water stored in the tank rises, and thus the thermoelectric element and the fan connected thereto are configured to operate continuously.

This is a problem in late-night hours when users are less likely to discharge purified water or cold water. In other words, since the thermoelectric element and the fan must continue to operate while purified water or cold water is not discharged, power efficiency is reduced, and there is a possibility that the user's sleep effect will be reduced by the noise caused by the fan's operation.

Korean Patent Laid-Open Publication No. 10-2009-0019614 discloses a water purifier having a dual cold water tank. Specifically, it discloses a water purifier having a structure that includes a sub-cold water tank that is connected to a water purification tank to store cold water, and a main cold water tank that receives purified water from the sub-cold water tank and cools it, and supplies water from the main cold water tank to the sub-cold water tank when the temperature difference between the water stored in the sub-cold water tank and the main cold water tank exceeds a reference value.

However, the above-mentioned related art document only provides a method for maintaining cold water at a desired temperature based on the temperature difference between water stored in the main cold water tank and the sub-cold water tank. That is, the above-mentioned related art document does not provide a method for stopping the operation of the cooling component when the frequency of water discharge is low, while maintaining the temperature of the already generated cold water.

Korean Patent Laid-Open Publication No. 10-2021-0131883 discloses a cooling apparatus and a cooling system for a water purifier using same. Specifically, it discloses a cooling apparatus having a structure in which a plurality of cold water tanks are arranged facing each other with a cold sink connected to a thermoelectric element therebetween, thereby preventing a decrease in the cooling performance of the thermoelectric element and increasing the flow rate of the cooling water, and a cooling system for a water purifier using the same.

However, the above-mentioned related art document does not provide a method for increasing power efficiency by varying the operating state of the thermoelectric element. That is, the above-mentioned related art document also does not provide a method for stopping the operation of the thermoelectric element when the frequency of water discharge is low, while maintaining the temperature of the already generated cold water.

Korean Patent Laid-Open Publication No. 10-2009-0019614 (2009. 02. 25.)

Korean Patent Laid-Open Publication No. 10-2021-0131883 (2021. 11. 03.)

### DISCLOSURE

### TECHNICAL PROBLEM

The present invention is to solve the above problems, and the present invention is directed to providing a cooling device having a structure capable of improving energy efficiency and a control method therefor.

The present invention is also directed to providing a cooling device having a structure capable of reducing noise generated when not in use for a long period of time and a control method therefor.

The present invention is also directed to providing a cooling device having a structure capable of maintaining the temperature of fluid even when not in use for a long period of time and a control method therefor.

The present invention is also directed to providing a cooling device having a structure capable of improving the cooling efficiency of a fluid and a control method therefor.

The present invention is also directed to providing a cooling device having a structure in which processing convenience can be improved and manufacturing cost can be reduced, and a control method therefor.

The problems of the present invention are not limited to those mentioned above, and other problems not mentioned will be clearly understood by those of ordinary skill in the art from the following description.

### TECHNICAL SOLUTION

According to an aspect of the present invention, provided is a cooling device, including: a main tank fluidly connected to the outside thereof to receive a fluid, store the received fluid, and deliver the stored fluid to the outside; a heat exchanger positioned adjacent to the main tank to cool the received fluid; and a sub-tank which is fluidly connected to the main tank to receive the fluid that has been delivered to the main tank and which is coupled to the heat exchanger to cool the received fluid, wherein the fluid introduced into the main tank is cooled by the heat exchanger while passing through the sub-tank and then is introduced back to the main tank.

In this case, a cooling device may be provided in which the sub-tank includes a sub-tank body coupled to the main tank and having a sub-tank space formed therein that is fluidly connected to the main tank; and a sub-tank cover covering the sub-tank space and coupled to the sub-tank body, and coupled to the heat exchanger to exchange heat with the heat exchanger.

In addition, a cooling device may be provided in which the sub-tank includes a tank flow passage part coupled to the sub-tank body and fluidly connected to the sub-tank space and the main tank space of the main tank, respectively; and a pump member fluidly connected to the tank flow passage part and configured to provide a transfer force so that the fluid accommodated in the main tank space flows to the sub-tank space.

In this case, a cooling device may be provided in which the sub-tank includes a first sub-communication part fluidly connected to the pump member and the sub-tank space, respectively, to form a flow passage through which the fluid is introduced into the sub-tank space; and a second sub-communication part fluidly connected to the sub-tank space and the main tank space, respectively, to form a flow passage through which the cooled fluid is discharged from the sub-tank space to the main tank space.

In addition, a cooling device may be provided in which the sub-tank body extends along one direction, the first sub-communication part, the tank flow passage part, and the pump member are positioned adjacent to one end in the extension direction of the sub-tank body, and the second sub-communication part is positioned adjacent to the other end in the extension direction of the sub-tank body.

In this case, a cooling device may be provided in which the sub-tank cover is formed of a material having a higher thermal conductivity than the material of the main tank and the material of the sub-tank body.

In addition, a cooling device may be provided in which the sub-tank cover is made of a material including copper (Cu), aluminum (Al), or stainless steel, and the main tank and the sub-tank body are formed of a synthetic resin material.

In this case, a cooling device may be provided in which the cooling device further includes a controller electrically connected to the heat exchanger and the sub-tank to control the operation of the heat exchanger and the sub-tank.

In addition, a cooling device may be provided in which the main tank include a main tank space formed therein and fluidly connected to the outside and the sub-tank; and a main temperature sensor coupled to the main tank to generate detection information about the fluid flowing in the main tank space, and the controller is electrically connected to the main temperature sensor to receive the generated detection information.

In this case, a cooling device may be provided in which the heat exchanger includes a thermoelectric element coupled to the sub-tank to exchange heat with the sub-tank and fluid introduced into the sub-tank; and a fan member coupled to the thermoelectric element to emit heat transferred to the thermoelectric element, and the controller is configured to compute operation information for controlling the operation of the thermoelectric element and the fan member using the detection information.

In addition, a cooling device may be provided in which the sub-tank includes a pump member fluidly connected to a sub-tank space formed inside the sub-tank and a main tank space formed inside the main tank, respectively, so that the fluid introduced into the main tank is discharged to the sub-tank, and the controller is configured to compute operation information for controlling the operation of the pump member using the detection information.

In addition, according to another aspect of the present invention, provided is a control method for a cooling device, the control method including: (a) computing, by a controller, state information about a state of a cooling device; (b) computing, by the controller, operation information for controlling a heat exchanger or a sub-tank provided in the cooling device using the computed state information; and (c) controlling, by the controller, the operation of the heat exchanger or the sub-tank according to the computed operation information.

In this case, a control method for a cooling device may be provided in which the step (a) includes (a1) generating, by a main temperature sensor, detection information about the temperature fluid flowing inside a main tank space; (a2) computing, by a state information computation module, temperature information using the generated detection information; and (a3) computing, by the state information computation module, water discharge information about whether fluid accommodated in the main tank space is discharged to a water discharge module.

In addition, a control method for a cooling device may be provided in which the step (b) includes (b1) computing, by a cooling information computation unit, cooling information about the operation of a thermoelectric element of the heat exchanger using the computed state information; (b2) computing, by a heat dissipation information computation unit, heat dissipation information about the operation of a fan member of the heat exchanger using the computed state information; and (b3) computing, by a flow passage information computation unit, flow passage information about the operation of a pump member of the sub-tank using the computed state information.

In this case, a control method for a cooling device may be provided in which the step (b1) includes (b11) comparing, by the cooling information computation unit, temperature information about the temperature of fluid flowing in a main tank space among the computed state information with a preset reference temperature range; (b12) computing, by the cooling information computation unit, the cooling information so that the thermoelectric element stops, if the temperature information falls within the reference temperature range; and (b13) computing, by the cooling information computation unit, the cooling information so that the thermoelectric element stops, if the computed temperature information is out of the reference temperature range.

In addition, a control method for a cooling device may be provided in which the step (b2) includes (b21) comparing, by the heat dissipation information computation unit, temperature information about the temperature of fluid flowing in a main tank space among the computed state information with a preset reference temperature range; (b22) computing, by the heat dissipation information computation unit, the heat dissipation information so that the fan member stops, if the temperature information falls within the reference temperature range; and (b23) computing, by the heat dissipation information computation unit, the heat dissipation information so that the fan member stops, if the temperature information is out of the reference temperature range.

In this case, a control method for a cooling device may be provided in which the step (b3) includes (b31) comparing, by the flow passage information computation unit, temperature information about the temperature of fluid flowing in a main tank space among the computed state information with a preset reference temperature range; (b32) computing, by the flow passage information computation unit, the flow passage information so that the pump member stops, if the temperature information falls within the reference temperature range; and (b33) computing, by the flow passage information computation unit, the flow passage information so that the pump member stops, if the temperature information is out of the reference temperature range.

In addition, a control method for a cooling device may be provided in which the step (b33) includes (b331) receiving, by the flow passage information computation unit, the computed cooling information; (b332) computing, by the flow passage information computation unit, timing information about timing when the thermoelectric element is operated among the content of the computed cooling information; and (b333) computing, by the flow passage information computation unit, the flow passage information so that the pump member operates after a preset time has elapsed from the computed timing information.

In this case, a control method for a cooling device may be provided in which the step (b33) includes (b334) receiving, by the flow passage information computation unit, the computed heat dissipation information; (b335) computing, by the flow passage information computation unit, timing information about timing when the fan member is operated among the content of the computed cooling information; and (b336) computing, by the flow passage information computation unit, the flow passage information so that the pump member operates after a preset time has elapsed from the computed timing information.

In addition, a control method for a cooling device may be provided in which the step (c) includes (c1) controlling, by a heat exchanger control module, the operation of a thermoelectric element of the heat exchanger according to cooling information among the computed operation information; (c2) controlling, by the heat exchanger control module, the operation of a fan member of the heat exchanger according to heat dissipation information among the computed operation information; and (c3) controlling, by a pump member control module, the operation of a pump member of the sub-tank according to flow passage information among the computed operation information.

### ADVANTAGEOUS EFFECT

According to the above configuration, the cooling device and the control method therefor according to an exemplary embodiment of the present invention can improve the energy efficiency.

The cooling device is provided with a main tank and a sub-tank communicating with the main tank. The main tank is fluidly connected to the outside of the cooling device to receive and store the filtered fluid. In addition, the fluid stored in the main tank may be discharged outside the water purifier through the water discharge module.

The sub-tank receives the fluid that is introduced into the main tank. The sub-tank is coupled to a heat exchanger, so that the fluid introduced into the sub-tank can be cooled by the heat exchanger. The cooled fluid is returned to the main tank and stored therein.

In an embodiment, the sub-tank may be formed to be smaller than the main tank. That is, compared to the case where the heat exchanger is directly connected to the main tank, the amount of power required for the heat exchanger to cool the fluid introduced into the sub-tank can be reduced.

In addition, the cooling device is provided with a controller that controls the components of the heat exchanger and the sub-tank. The controller computes control information for controlling the components of the heat exchanger and the sub-tank using temperature information of the fluid accommodated in the main tank or water discharge information about whether fluid is discharged from the main tank. The controller can control the heat exchanger and the sub-tank in accordance with the computed control information.

In an embodiment, if the temperature of the fluid stored in the main tank falls within a preset reference temperature range, the controller can stop the operation of the heat exchanger and the sub-tank. In addition, if no fluid flows out of the main tank to the outside of the cooling device for a preset reference time, the controller can stop the operation of the heat exchanger and the sub-tank.

Therefore, if the temperature of the fluid stored in the main tank is sufficiently low, or if the fluid stored in the main tank does not continuously flow out, the operation of the heat exchanger or the sub-tank can be automatically stopped. Accordingly, the amount of power required for the operation of the cooling device is reduced, and thus energy efficiency can be improved.

In addition, according to the above configuration, the cooling device and the control method therefor according to an exemplary embodiment of the present invention can reduce noise generated when not in use for a long time.

As described above, if fluid does not flow out from the main tank to the outside of the cooling device for a predetermined time, the controller can control the heat exchanger or the sub-tank to stop the operation.

Therefore, when not in use for a long time, the operation of the fan member, which is the main noise source, is stopped, thereby reducing noise generated by the cooling device.

In addition, according to the above configuration, the cooling device and the control method therefor according to an exemplary embodiment of the present invention can maintain the temperature of the fluid even when not in use for a long time.

The heat exchanger is coupled to the sub-tank. The cooled fluid is stored in the main tank spaced apart from the heat exchanger. The main tank body forming the outer shape of the main tank is formed of an insulating material, so that heat exchange between the fluid stored in the main tank and the outside can be minimized.

In addition, even if the operation of the heat exchanger is stopped, the fluid stored inside the main tank does not directly exchange heat with the heat exchanger. Therefore, the temperature of the fluid stored in the main tank can be maintained in a cooled state.

Meanwhile, the sub-tank and the main tank are fluidly connected by the sub-communication part and the tank flow passage part. In an embodiment, check valves opened or closed due to a difference in pressure may be provided in the sub-communication part and the tank flow passage part. When the operation of the pump member is stopped, the check valves close the sub-communication part and the tank flow passage part to block the communication between the sub-tank and the main tank. The pump member can be operated corresponding to the operation of the heat exchanger.

Therefore, if the operation of the heat exchanger is stopped, the pump member can also be stopped, thereby blocking the communication between the main tank and the sub-tank. Accordingly, the fluid stored in the main tank is not mixed with the fluid stored in the sub-tank, so that the temperature can be maintained in a cooled state.

In addition, according to the above configuration, the cooling device and the control method therefor according to an exemplary embodiment of the present invention can improve the cooling efficiency of the fluid.

A main partition wall member forming a flow passage through which fluid flows is provided inside the main tank. The main partition wall member divides the internal space of the main tank into a plurality of spaces communicating with each other. Fluid can be stored while flowing in a zigzag shape along the main partition wall member in the plurality of partitioned spaces.

As described above, the fluid cooling process is performed in the sub-tank directly coupled to the heat exchanger. Therefore, since the cooled fluid is introduced into the main tank, heat exchange efficiency due to convection in the main tank can be improved.

In an embodiment, the fluid cooled in the sub-tank can be introduced into the main tank through the upper side of the main tank. In addition, the fluid in the main tank can flow out to the sub-tank through the lower side of the main tank.

Therefore, the temperature gradient of the fluid inside the main tank can be minimized. As a result, the cooling efficiency of the fluid can be improved.

In addition, according to the above configuration, the cooling device and the control method therefor according to an exemplary embodiment of the present invention can improve processing convenience and reduce manufacturing costs.

As described above, the heat exchanger is directly coupled to the sub-tank. Therefore, the main tank can be formed of a material capable of blocking an external heat exchange with fluid stored therein. In other words, expensive insulating materials are used only for components that directly contact the heat exchanger among the components of the sub-tank, and other components of the main tank and other components of the sub-tank can achieve a sufficient cooling effect even if they are formed of insulating materials.

In the case of insulating materials, the manufacturing cost is lower and the process required for manufacturing is simple compared to materials with high thermal conductivity such as synthetic resins or Styrofoam. Therefore, processing convenience of each component of the cooling device and the cooling device can be improved and manufacturing cost can be reduced.

Advantageous effects of the present invention are not limited to the above-described effects, and should be understood to include all effects that can be inferred from the configuration of the invention described in the detailed description or claims of the present invention.

### BRIEF DESCRIPTION OF THE DRAWINGS

FIG. 1 is a block diagram illustrating a configuration of a water purifier according to an exemplary embodiment of the present invention.
FIG. 2 is a perspective view illustrating a cooling device according to an exemplary embodiment of the present invention.
FIG. 3 is an exploded perspective view illustrating the cooling device of FIG. 2.
FIG. 4 is a perspective view illustrating a main tank provided in the cooling device of FIG. 2.
FIG. 5 is a front view illustrating the main tank of FIG. 4.
FIG. 6 is a perspective view illustrating a coupling frame provided in the cooling device of FIG. 2.
FIG. 7 is a perspective view illustrating a heat exchanger provided in the cooling device of FIG. 2.
FIG. 8 is a perspective view illustrating a sub-tank provided in the cooling device of FIG. 2.
FIG. 9 is an exploded perspective view illustrating the sub-tank of FIG. 8.
FIG. 10 is a B-B cross-sectional perspective view illustrating the sub-tank of FIG. 8.
FIG. 11 is an A-A cross-sectional view illustrating a fluid flow passage formed inside the cooling device of FIG. 2.
FIG. 12 is a block diagram illustrating a configuration for implementing a control method of a cooling device according to an exemplary embodiment of the present invention.
FIG. 13 is a flowchart illustrating a flow of a control method of a cooling device according to an exemplary embodiment of the present invention.
FIG. 14 is a flowchart illustrating a detailed flow of step S100 in the control method of the cooling device of FIG. 13.
FIG. 15 is a flowchart illustrating a detailed flow of step S200 in the control method of the cooling device of FIG. 13.
FIG. 16 is a flowchart illustrating a detailed flow of step S210 in the control method of the cooling device of FIG. 15.
FIG. 17 is a flowchart illustrating a detailed flow of step S220 in the control method of the cooling device of FIG. 15.
FIG. 18 is a flowchart illustrating a detailed flow of step S230 in the control method of the cooling device of FIG. 15.
FIG. 19 is a flowchart illustrating a detailed flow of step S233 in the control method of the cooling device of FIG. 18.
FIG. 20 is a flowchart illustrating a detailed flow of step S300 in the control method of the cooling device of FIG. 15.

### MODES OF THE INVENTION

Hereinafter, exemplary embodiments of the present invention will be described in detail so that those of ordinary skill in the art can readily implement the present invention with reference to the accompanying drawings. The present invention may be embodied in many different forms and is not limited to the embodiments set forth herein. In the drawings, parts unrelated to the description are omitted for clarity of description of the present invention, and throughout the specification, same or similar reference numerals denote same elements.

Terms and words used in the present specification and claims should not be construed as limited to their usual or dictionary definition. They should be interpreted as meaning and concepts consistent with the technical idea of the present invention, based on the principle that inventors may appropriately define the terms and concepts to describe their own invention in the best way.

Accordingly, the embodiments described in the present specification and the configurations shown in the drawings correspond to preferred embodiments of the present invention, and do not represent all the technical idea of the present invention, so the configurations may have various examples of equivalent and modification that can replace them at the time of filing the present invention.

In the following description, in order to clarify the features of the present invention, descriptions of some components may be omitted.

The term "communication" used in the following description means that one or more members are connected to each other so as to be in fluid communication. In an embodiment, the communication may be formed by a member such as a conduit, a pipe, a tubing, or the like. In the following description, communication may be used in the same sense as one or more members are being "fluidly connected" to each other.

The term "electrical conduction or electrically conducted or energization" used in the following description means that one or more members are connected to each other so as to transmit an electric current or an electrical signal. In an embodiment, the electrical conduction may be formed in a wired form by a wire member or the like or in a wireless form such as Bluetooth, Wi-Fi, RFID, or the like. In an embodiment, the electrical conduction may include the meaning of "electrical communication."

The term "fluid" used in the following description refers to any form of material that flows by external force and whose shape or volume can be changed. In an embodiment, the fluid may be a liquid such as water or a gas such as air.

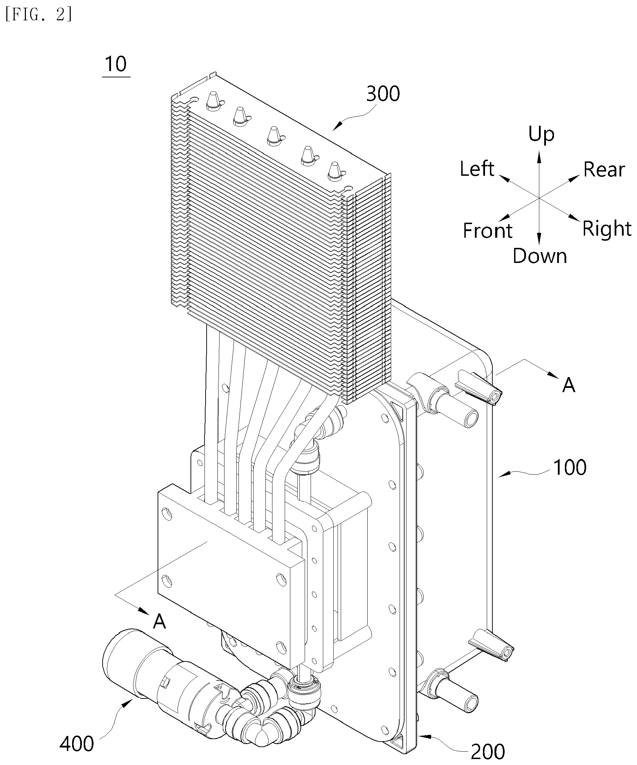

The terms "above or upper side", "below or lower side", "left side", "right side", "front side", and "rear side" used in the following description will be understood with reference to the coordinate system shown in FIG. 2.

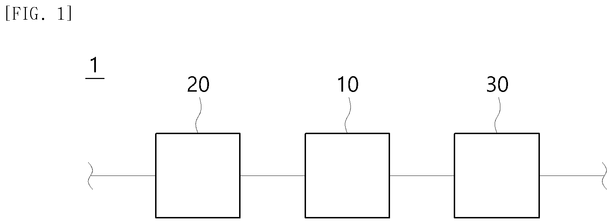

Referring to FIG. 1, the communication relationship of each component of a water purifier 1 including a cooling device 10 according to an exemplary embodiment of the present invention is disclosed in a block diagram.

The water purifier 1 is fluidically connected to the outside and may receive unfiltered fluid, for example, raw water. The water purifier 1 may include a filtration module 20 for filtering the unfiltered fluid. The filtration module 20 may be provided in any form, such as a filter capable of filtering raw water. Fluid introduced into the water purifier 1 may be filtered by passing through the filtration module 20.

In addition, the water purifier 1 may include any means for heating or cooling the filtered fluid (i.e., a cooling device 10 to be described later). The filtered fluid may be discharged to the outside and provided to the user after being adjusted to the user's desired temperature.

In addition, the water purifier 1 may be fluidically connected to the outside and include any means for heating or cooling the filtered fluid (i.e., a cooling device 10).

In the illustrated embodiment, the water purifier 1 includes a cooling device 10, a filtration module 20, and a water discharge module 30.

The cooling device 10 is configured to cool the fluid filtered by the filtration module 20. The cooling device 10 can cool the fluid by exchanging heat with the filtered fluid. The cooled fluid may be discharged externally and provided to the user.

The cooling device 10 may be provided in any form for cooling the filtered fluid. The cooling device 10 may be energizably connected to an external power source (not shown) to receive the electric power required for operation. Although not shown, the water purifier 1 may further include an input device (not shown) for receiving a control signal for operating the cooling device 10.

A detailed description of each component of the cooling device 10 and a process of flowing out after the fluid is introduced and cooled will be described later.

The cooling device 10 is fluidly connected to the outside of the water purifier 1 through the filtration module 20. In addition, the cooling device 10 is fluidly connected to the outside of the water purifier 1 through the water discharge module 30.

The filtration module 20 receives unfiltered fluid and filters it to suit the intended use. The filtration module 20 is fluidly connected to the outside of the water purifier 1 and the cooling device 10. The filtered fluid while passing through the filtration module 20 may be transferred to the cooling device 10.

The water discharge module 30 is fluidly connected to the outside to transfer the fluid that passes through the cooling device 10 to the outside. The water discharge module 30 fluidly connects the cooling device 10 to the outside.

The water discharge module 30 may be provided in any form capable of fluidly connecting the cooling device 10 to the outside of the water purifier **1.** In an embodiment, the water discharge module 30 may be provided in the form of a pipe. In the above embodiment, a valve operated in various forms may be provided in the water discharge module 30 to control the outflow of the cooled fluid.

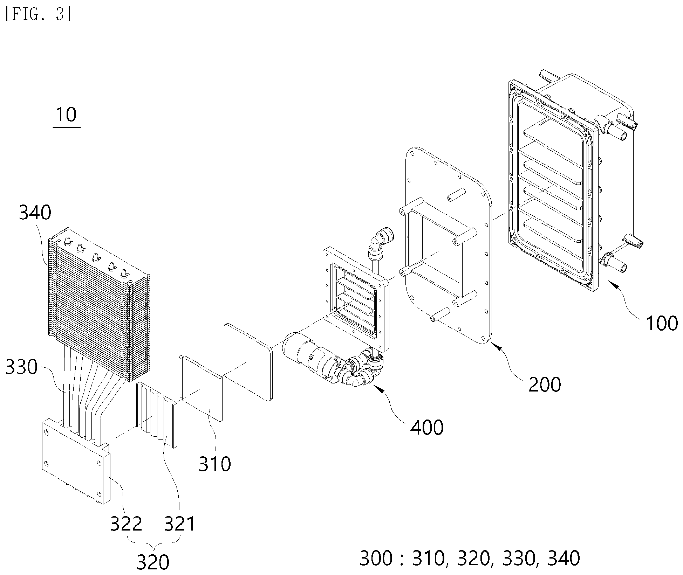

Referring to FIGS. 2 to 3, a cooling device 10 according to an exemplary embodiment of the present invention is shown.

The cooling device 10 is accommodated inside the water purifier 1, and is fluidly connected to the filtration module 20 and the water discharge module 30, respectively. The cooling device 10 may cool the fluid introduced after being filtered while passing through the filtration module 20. The cooled fluid may be discharged along the water discharge module 30.

The cooling device 10 according to an exemplary embodiment of the present invention may include a plurality of members for storing fluid. That is, the cooling device 10 according to an exemplary embodiment of the present invention may be formed in a tank type. One of the plurality of members is fluidly connected to the filtration module 20 and the water discharge module 30. The filtered fluid may be introduced into the one and may be discharged through the water discharge module 30.

Another of the plurality of members is fluidly connected to the one member. The fluid passing through the filtration module 20 passes through the one and is introduced into the aforementioned another member.

A component for cooling the introduced fluid is coupled to the aforementioned another member. That is, the cooling process of the fluid is performed in the component of the aforementioned another member.

In this case, the aforementioned another member may be formed to have a smaller size than the one member. Therefore, the power required to cool the introduced fluid may be reduced. In addition, since the cooled fluid is transferred to the one member and stored therein, the cooled fluid temperature can be maintained even if the fluid cooling process is not performed.

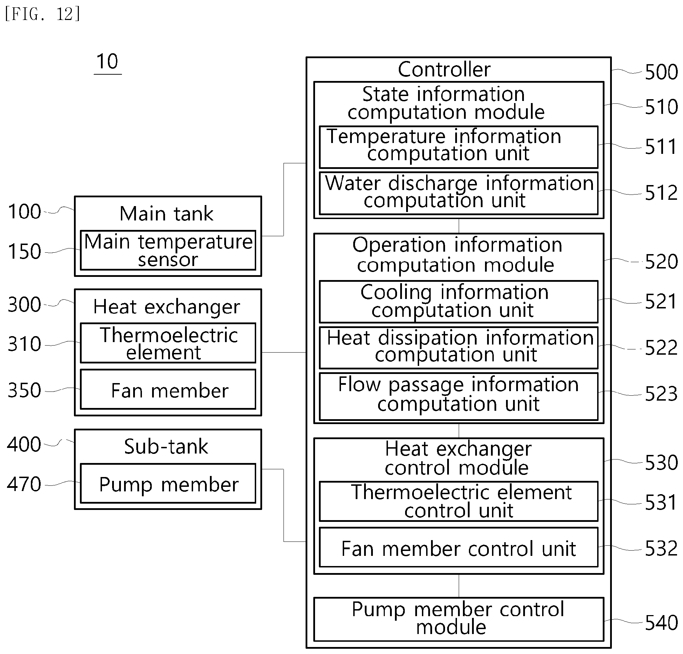

In the embodiments shown in FIGS. 2 to 3, the cooling device 10 includes a main tank 100, a coupling frame 200, a heat exchanger 300, and a sub-tank 400. In addition, referring further to FIG. 12, the cooling device 10 according to the illustrated embodiment further includes a controller 500.

The main tank 100 forms a part of the outer shape of the cooling device 10. The main tank 100 is a part where the cooling device 10 is fluidly connected to other components of the water purifier 1, that is, the filtration module 20 and the water discharge module 30.

The filtered fluid while passing through the filtration module 20 may be introduced into the main tank 100. In addition, the fluid flowing in the main tank 100 may be discharged to the outside through the water discharge module 30. To this end, a space communicating with the outside is formed inside the main tank 100.

The main tank 100 forms one side of the cooling device 10. In the illustrated embodiment, the main tank 100 forms a rear side of the cooling device 10.

The main tank 100 is coupled to the coupling frame 200. The main tank 100 is coupled to the sub-tank 400 through the coupling frame 200. In the illustrated embodiment, the sub-tank 400, the coupling frame 200, and the main tank 100 are sequentially arranged in a direction from the front side to the rear side.

The main tank 100 is coupled to the sub-tank 400. The main tank 100 may be fluidly connected to the sub-tank 400 by a sub-communication part 450 and a tank flow passage part 460 provided in the sub-tank 400.

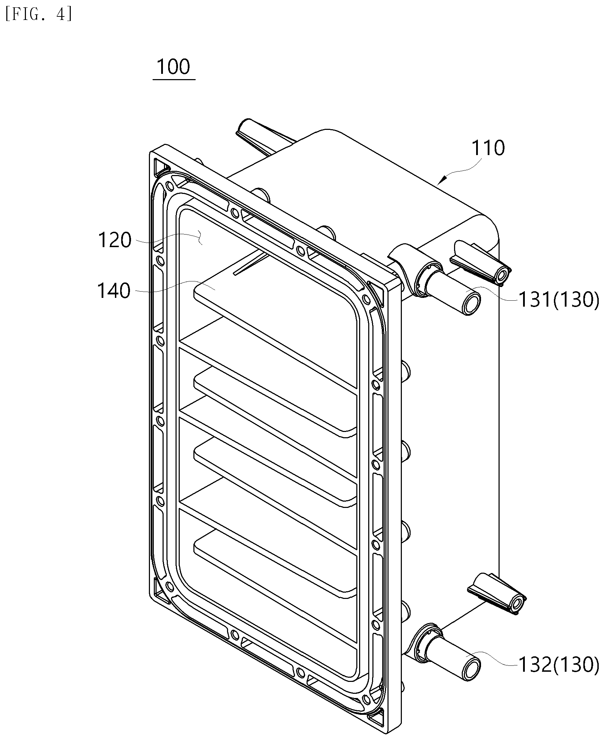

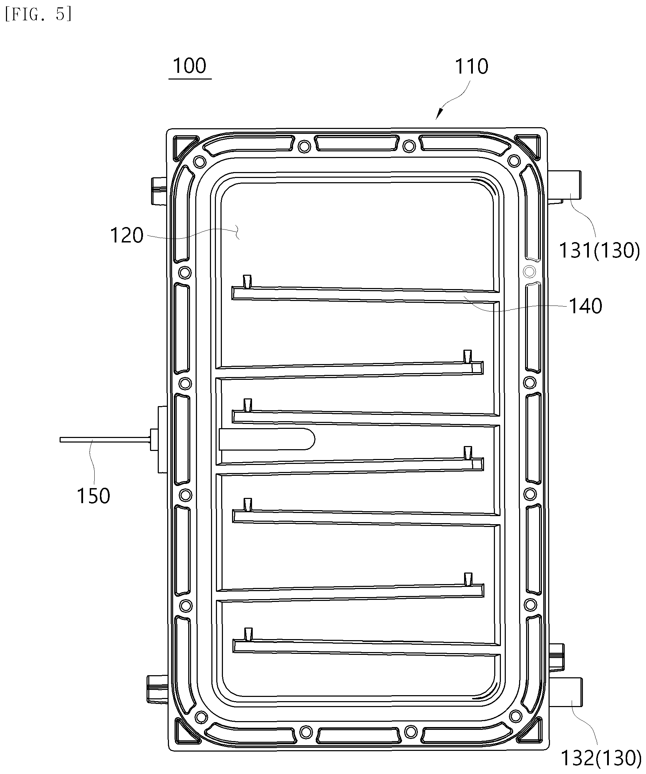

In the embodiments shown in FIGS. 4 to 5, the main tank 100 includes a main tank body 110, a main tank space 120, a main communication part 130, a main partition wall member 140, and a main temperature sensor 150.

The main tank body 110 forms an outer shape of the main tank 100. A space (i.e., a main tank space 120 to be described later) is formed inside the main tank body 110. The space is fluidly connected to the outside so that fluid may be introduced therein or be discharged therefrom.

The main tank body 110 is coupled to the coupling frame 200. The space formed inside the main tank body 110 may be closed by the coupling frame 200. In the illustrated embodiment, the front side of the main tank body 110 is coupled to the coupling frame 200.

The main tank body 110 may be formed to have a size larger than that of a sub-tank body 410 provided in the sub-tank 400. In other words, the main tank body 110 may have a space formed therein (i.e., the main tank space 120) having a larger volume than a sub-tank space 420 formed inside the sub-tank body 410.

Accordingly, the amount of fluid staying in the main tank 100 is increased compared to the amount of fluid cooled in the sub-tank 400. As a result, the fluid passing through the filtration module 20 may be continuously cooled and then may be introduced into the main tank 100.

The main tank body 110 may have a main tank space 120 formed therein and may have an arbitrary shape that may be coupled to the coupling frame 200. In the illustrated embodiment, the main tank body 110 has a polygonal pillar shape having a width in the left-right direction, a height in the up-down direction, and a depth in the front-rear direction.

The main tank body 110 may be formed of an insulating or heat-retaining material. This is to prevent a situation in which the fluid stored in the main tank space 120 is heated or cooled by heat exchange with the outside. In an embodiment, the main tank body 110 may be formed of a synthetic resin material. In another embodiment, the main tank body 110 may be surrounded by an insulating material such as foamed Styrofoam.

That is, in the main tank body 110 according to an exemplary embodiment of the present invention, the fluid accommodated in the main tank space 120 is not directly cooled. Therefore, even if the main tank body 110 is not formed of a material with a high heat transfer rate that is relatively expensive, the fluid can be cooled and provided to the outside. Accordingly, the manufacturing cost of the main tank 100 and the cooling device 10 can be reduced, and the manufacturing process can be simplified.

The main tank space 120 is a space formed inside the main tank body 110. The main tank space 120 receives and stores filtered fluid or cooled fluid.

The main tank space 120 is fluidly connected to the outside. The main tank space 120 is fluidly connected to the filtration module 20 and the water discharge module 30, respectively. The fluid filtered while passing through the filtration module 20 is introduced into the main tank space 120 through the main communication part 130. In addition, the fluid accommodated in the main tank space 120 is discharged to the water discharge module 30 through the main communication part 130.

The main tank space 120 is fluidly connected to the sub-tank space 420. Specifically, the main tank space 120 is fluidly connected to the sub-tank space 420 by the sub-communication part 450 and the tank flow passage part 460.

The fluid introduced into the main tank space 120 from the filtration module 20 may be discharged into the sub-tank space 420. The fluid cooled in the sub-tank space 420 may be introduced back into the main tank space 120. That is, the fluid passing through the filtration module 20 may be cooled and stored while circulating through the main tank space 120 and the sub-tank space 420.

Therefore, it will be understood that the fluid introduced from the filtration module 20 and the fluid introduced from the sub-tank space 420 may be mixed and stored in the main tank space 120.

The main tank space 120 may have a shape corresponding to the shape of the main tank body 110. In the illustrated embodiment, the main tank space 120 is a polygonal pillar-shaped space having a width in the left-right direction, a height in the up-down direction, and a depth in the front-rear direction.

The main tank space 120 is partially surrounded by the inner circumference of the main tank body 110. Among each side of the main tank space 120, one side toward the coupling frame 200, that is, the front side in the illustrated embodiment, is closed by the coupling frame 200. Among the other sides of the main tank space 120, the other side on which the main communication part 130 is disposed, that is, the right side in the illustrated embodiment, communicates with the filtration module 20 and the water discharge module 30, respectively, by the main communication part 130.

The main communication part 130 is coupled to the main tank body 110 to fluidly connect the main tank space 120 to the outside.

The main communication part 130 is disposed on one surface of each surface of the main tank body 110, that is, on the right side surface in the illustrated embodiment. The main communication part 130 is formed to protrude outward from the one surface of the main tank body 110. Although not shown, a fitting member or the like may be coupled to the main communication part 130 to be fluidly connected to other components.

A hollow is formed inside the main communication part 130. The hollow may penetrate from one end of the main communication part 130 in the protruding direction, that is, the right end in the illustrated embodiment, to the one surface of the main tank body 110, that is, the right side surface to communicate with the main tank space 120 and the outside, respectively.

A plurality of main communication parts 130 may be formed. The plurality of main communication parts 130 may be spaced apart from each other in the height direction of the main tank body 110 to be fluidly connected to the filtration module 20 and the water discharge module 30, respectively.

In the illustrated embodiment, the main communication part 130 includes a first main communication part 131 that is biased to the upper side and a second main communication part 132 that is biased to the lower side.

One of the first main communication part 131 and the second main communication part 132 is fluidly connected to the filtration module 20. The other one of the first main communication part 131 and the second main communication part 132 is fluidly connected to the water discharge module 30.

In an embodiment, the first main communication part 131 positioned on the upper side is fluidly connected to the filtration module 20 so that filtered fluid may be introduced. In addition, the second main communication part 132 positioned on the lower side is fluidly connected to the water discharge module 30 so that cooled fluid may be discharged.

The main partition wall member 140 divides the main tank space 120 into a plurality of small spaces communicating with each other. The main partition wall member 140 is disposed inside the main tank space 120.

The main partition wall member 140 extends from the inner surface of the main tank body 110 surrounding the main tank space 120. In the illustrated embodiment, the main partition wall member 140 extends from the left inner surface or the right inner surface of the main tank body 110.

The main partition wall member 140 may have an arbitrary shape capable of dividing the main tank space 120 into a plurality of small spaces. In the illustrated embodiment, the main partition wall member 140 is provided in a plate shape having a length in the left-right direction, a thickness in the up-down direction, and a width in the front-rear direction.

In this case, the length in the left-right direction of the main partition wall member 140 may be shorter than that in the left-right direction of the main tank space 120. Accordingly, one end in the extension direction of the main partition wall member 140 is spaced apart from the inner surface of the main tank body 110 to form a space therebetween. Through the space, the plurality of partitioned small spaces may communicate with each other.

In this case, the width in the front-rear direction of the main partition wall member 140 may be the same as the depth in the front-rear direction of the main tank space 120. That is, each edge in the width direction of the main partition wall member 140 is in contact with the rear side surface of the main tank body 110 and the frame body 210, respectively. Therefore, the fluid flowing along the main partition wall member 140 in one small space may be introduced into another small space only through the above space.

A plurality of main partition wall members 140 may be formed. The plurality of main partition wall members 140 may be spaced apart from each other in the height direction of the main tank space 120, that is, in the up-down direction in the illustrated embodiment. In this case, the main partition wall members 140 adjacent to each other may extend from different surfaces of the inner surface of the main tank body 110.

Therefore, the fluid flowing in the main tank space 120 may flow along a zigzag-shaped flow path along the main partition wall members 140 alternately arranged with each other.

The main temperature sensor 150 generates detection information about the temperature of the fluid accommodated in the main tank space 120. The main temperature sensor 150 is coupled to the main tank body 110, and a portion thereof is exposed to the main tank space 120. In the illustrated embodiment, the main temperature sensor 150 is coupled to the left side surface of the main tank body 110, with a portion thereof exposed toward the center in the height direction of the main tank space 120 while being offset to the left.

The main temperature sensor 150 is electrically conducted with the controller 500. The detection information generated by the main temperature sensor 150 may be transmitted to the controller 500.

In the illustrated embodiment, a single main temperature sensor 150 is provided. Alternatively, a plurality of main temperature sensors 150 may be provided to be spaced apart from each other along the height direction of the main tank space 120.

The coupling frame 200 is coupled to the main tank 100 and the sub-tank 400, respectively. The main tank 100 and the sub-tank 400 are coupled to each other via the coupling frame 200.

The coupling frame 200 is located between the main tank 100 and the sub-tank 400. In the illustrated embodiment, the coupling frame 200 is positioned on the front side of the main tank 100 and on the rear side of the sub-tank 400.

The coupling frame 200 is coupled to the main tank 100. The coupling frame 200 is coupled to the main tank body 110 while covering one open side of the main tank space 120, that is, the front side in the illustrated embodiment. The one side of the main tank space 120 is closed by the coupling frame 200.

The coupling frame 200 is coupled to the sub-tank 400. A space (i.e., a sub-tank accommodation part 221 to be described later) may be formed inside the coupling frame 200 to accommodate the sub-tank body 410.

In addition, a through hole (i.e., a tank communication part 230 to be described later) is formed inside the coupling frame 200 to communicate the main tank space 120 and the sub-tank space 420.

The coupling frame 200 may be formed of an insulating or heat-retaining material. This is to prevent a situation in which the fluid stored in the main tank space 120 is heated or cooled by heat exchange with the coupling frame 200. In addition, this is to prevent a situation in which the temperature of the fluid cooled in the sub-tank space 420 rises by heat exchange with the coupling frame 200.

In an embodiment, the coupling frame 200 may be formed of a synthetic resin material. In another embodiment, the coupling frame 200 may be surrounded by an insulating material such as foamed Styrofoam.

Therefore, even if the coupling frame 200 is not formed of a material with a high heat transfer rate that is relatively expensive, the fluid can be cooled and provided to the outside. Accordingly, the manufacturing cost of the coupling frame 200 and the cooling device 10 can be reduced, and the manufacturing process can be simplified.

The coupling frame 200 may have a shape corresponding to the shapes of the main tank 100 and the sub-tank 400. In the illustrated embodiment, among each side of the coupling frame 200, one side toward the main tank 100, that is, the rear side, may be formed to have a size corresponding to the size of the main tank body 110 to completely cover and close the main tank space 120.

In addition, among each side of the coupling frame 200, the other side toward the sub-tank 400, that is, the front side, may be formed in a shape corresponding to the shape of the sub-tank body 410 and sub-communication part 450, so that it may accommodate the sub-tank body 410 and combine and communicate with the sub-communication part 450.

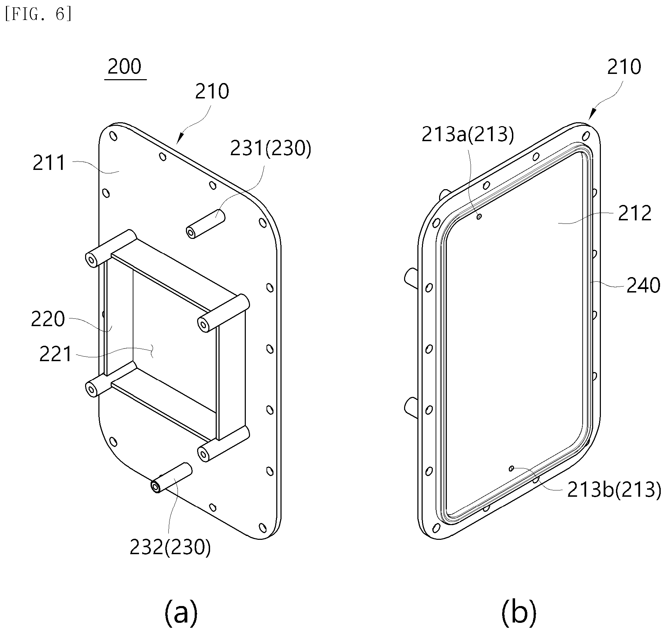

In an embodiment shown in FIG. 6, the coupling frame 200 includes a frame body 210, a tank coupling part 220, a tank communication part 230, and a sealing member 240.

The frame body 210 forms a part of the outer shape of the coupling frame 200. The frame body 210 is coupled to other components of the coupling frame 200 to support them. In the illustrated embodiment, the frame body 210 is coupled to the tank coupling part 220, the tank communication part 230, and the sealing member 240 to support them.

The frame body 210 is coupled to the main tank 100. Specifically, the frame body 210 covers the main tank space 120 and is coupled to the main tank body 110. To this end, the frame body 210 may be formed in a shape corresponding to the shape of the main tank body 110 or the main tank space 120.

In the illustrated embodiment, the frame body 210 is formed in a polygonal plate shape with a length in the left-right direction, a height in the up-down direction, and a thickness in the front-rear direction.

In the embodiment shown in FIG. 6, the frame body 210 includes a first frame surface 211, a second frame surface 212, and a frame communication hole 213.

The first frame surface 211 is one surface toward the sub-tank 400 among surfaces of the frame body 210. In the illustrated embodiment, the first frame surface 211 may be defined as the front side surface of the frame body 210.

The tank coupling part 220 is located on the first frame surface 211. In addition, the tank communication part 230 is formed on the first frame surface 211, extending in a direction toward the sub-tank 400, that is, toward the front side in the illustrated embodiment.

The second frame surface 212 is disposed to face the first frame surface 211.

The second frame surface 212 is the other surface toward the main tank 100 among surfaces of the frame body 210. In the illustrated embodiment, the second frame surface 212 may be defined as the rear side surface of the frame body 210.

The sealing member 240 is located on the second frame surface 212. The sealing member 240 is located radially inside the outer circumference of the second frame surface 212 and extends along the outer circumference of the second frame surface 212.

The second frame surface 212 is positioned to cover the main tank space 120. In other words, the fluid accommodated in the main tank space 120 may be in contact with the second frame surface 212.

The frame communication hole 213 is formed on the first frame surface 211 and the second frame surface 212.

The frame communication hole 213 is a portion through which the coupling frame 200 communicates with the main tank 100 and the sub-tank 400. The frame communication hole 213 communicates with the main tank space 120 and the sub-tank space 420, respectively.

The frame communication hole 213 is formed on the first frame surface 211 and the second frame surface 212. In an embodiment, the frame communication hole 213 may be formed to penetrate in the thickness direction of the frame body 210, that is, in the front-rear direction in the illustrated embodiment.

A portion of the frame communication hole 213 formed on the first frame surface 211 may communicate with a hollow formed inside the tank communication part 230. The other portion of the frame communication hole 213 formed on the second frame surface 212 may communicate with the main tank space 120.

A plurality of frame communication holes 213 may be formed. The plurality of frame communication holes 213 may be spaced apart from each other to communicate the main tank space 120 and the sub-tank space 420 at a plurality of portions.

In the illustrated embodiment, the frame communication hole 213 includes a first frame communication hole 213a located at the upper side and a second frame communication hole 213b located at the lower side.

The first frame communication hole 213a communicates the first tank communication part 231 positioned at the upper side and the main tank space 120. The first frame communication hole 213a communicates with a hollow formed inside the first tank communication part 231. The first frame communication hole 213a may be disposed to overlap the first tank communication part 231 along the thickness direction of the frame body 210, that is, along the front-rear direction in the illustrated embodiment.

The second frame communication hole 213b communicates the second tank communication part 232 positioned at the lower side and the main tank space 120. The second frame communication hole 213b communicates with a hollow formed inside the second tank communication part 232. The second frame communication hole 213b may be disposed to overlap the second tank communication part 232 along the thickness direction of the frame body 210, that is, along the front-rear direction in the illustrated embodiment.

The tank coupling part 220 is a portion in which the coupling frame 200 is coupled to the sub-tank body 410 of the sub-tank 400. The tank coupling part 220 is located on the first frame surface 211. In the illustrated embodiment, the tank coupling part 220 is formed at a central portion in the up-down direction and the left-right direction of the first frame surface 211.

The tank coupling part 220 may be formed to surround the sub-tank body 410 from the outside. In the illustrated embodiment, the tank coupling part 220 includes a plurality of plates extending in a direction from the first frame surface 211 toward the sub-tank 400, that is, toward the front side. The plurality of plates include one pair extending in the left-right direction and the other pair extending in the up-down direction.

The one pair of plates and the other pair of plates are continuous with each other. In addition, each pair of plates are placed apart from each other.

Therefore, the outer circumferential direction of the sub-tank body 410 accommodated in the tank coupling part 220 is supported by the one pair of plates and the other pair of plates.

A space formed between each pair of the plates spaced apart from each other is defined as a sub-tank accommodation part 221.

The sub-tank accommodation part 221 is a space for accommodating the sub-tank body 410. The sub-tank accommodation part 221 is defined as being surrounded by a plurality of plates constituting the tank coupling part 220. The outer side of the sub-tank body 410 accommodated in the sub-tank accommodation part 221 is supported by the plurality of plates.

Among each side of the sub-tank accommodation part 221, one side toward the sub-tank 400, that is, the front side, may be open to form a passage through which the sub-tank body 410 is accommodated. Among each side of the sub-tank accommodation part 221, the other side toward the main tank 100, that is, the rear side, is closed by the first frame surface 211, so that the insertion distance of the sub-tank body 410 may be limited.

The tank communication part 230 is a portion where the coupling frame 200 is fluidly connected to the sub-tank 400. A hollow may be formed inside the tank communication part 230 to communicate with the sub-tank space 420.

In addition, the tank communication part 230 communicates with the main tank space 120 through the frame communication hole 213. The fluid introduced into the main tank space 120 may pass through the frame communication hole 213 and the tank communication part 230 to flow out into the sub-tank space 420. In addition, the fluid cooled in the sub-tank space 420 may pass through the tank communication part 230 and the frame communication hole 213 to flow out into the main tank space 120.

The tank communication part 230 is located on the first frame surface 211. The tank communication part 230 is formed to extend toward the sub-tank 400, that is, toward the front side in the illustrated embodiment.

The tank communication part 230 may have an arbitrary shape that may be coupled to and communicate with the sub-communication part 450 or the tank flow passage part 460. In the illustrated embodiment, the tank communication part 230 has a cylindrical shape with a circular cross-section and a height in the front-rear direction. In this case, a hollow formed through in the extension direction, that is, in the front-rear direction of the tank communication part 230 is formed inside the tank communication part 230.

A plurality of tank communication parts 230 may be provided. The plurality of tank communication parts 230 may be coupled to the sub-communication part 450 and the tank flow passage part 460 of the sub-tank 400, respectively. In the illustrated embodiment, the tank communication part 230 includes a first tank communication part 231 positioned on the upper side and a second tank communication part 232 positioned on the lower side.

The first tank communication part 231 is coupled to a second sub-communication part 452 of the sub-communication part 450. The first tank communication part 231 is fluidly connected to the second sub-communication part 452 to form a flow passage through which the fluid cooled in the sub-tank space 420 is introduced into the main tank space 120. The first tank communication part 231 is disposed to overlap the first frame communication hole 213a to communicate with the first frame communication hole 213a.

The second tank communication part 232 is coupled to the tank flow passage part 460. The second tank communication part 232 is fluidly connected to the tank flow passage part 460 to form a flow passage through which the fluid introduced into or stored in the main tank space 120 is introduced into the sub-tank space 420. The second tank communication part 232 is disposed to overlap the second frame communication hole 213b to communicate with the second frame communication hole 213b.

The sealing member 240 seals the coupling portion between the frame body 210 and the main tank body 110. The main tank space 120 covered by the frame body 210 may be reliably sealed by the sealing member 240.

The sealing member 240 is located on the second frame surface 212. The sealing member 240 extends radially inside the outer circumference of the second frame surface 212 along the outer circumference of the second frame surface 212. The sealing member 240 may extend along the inner surface of the main tank body 110 surrounding the main tank space 120.

The sealing member 240 may be provided in an arbitrary form that can be pressed by an external force to seal and couple the coupling frame 200 and the main tank 100. In an embodiment, the sealing member 240 may be formed of an elastic material such as rubber or silicone.

The heat exchanger 300 is configured to cool the fluid by exchanging heat with the fluid introduced into the sub-tank space 420. The heat of the fluid may be discharged to the outside of the cooling device 10 through the heat exchanger 300.

The heat exchanger 300 is coupled to the sub-tank 400. In the illustrated embodiment, the heat exchanger 300 may be located on the front side of the sub-tank 400 to perform heat exchange by contacting the sub-tank 400. In other words, the heat exchanger 300 is disposed to face the coupling frame 200 or the main tank 100 with the sub-tank 400 interposed therebetween.

As the heat exchanger 300 is coupled to the sub-tank 400 instead of the main tank 100 and heat-exchanged, the size of the heat exchanger 300 may be reduced. In addition, since the amount of fluid that the heat exchanger 300 needs to cool at one point in time is reduced, the power required for the operation of the heat exchanger 300 may also be reduced. Accordingly, the operating time or operating speed of a fan member 350 for discharging the heat transferred to the heat exchanger 300 to the outside may also be reduced.

The heat exchanger 300 exchanges heat with the sub-tank 400 to receive heat from the sub-tank 400. Accordingly, the sub-tank 400 and the fluid accommodated in the sub-tank 400 may be cooled. As a result, the heat exchanger 300 may receive heat of the fluid introduced into the sub-tank 400 so that the fluid may be cooled. The heat exchanger 300 may discharge the received heat to the outside.

The heat exchanger 300 is coupled to the sub-tank 400. Some components of the heat exchanger 300 may be in direct contact with the sub-tank 400 to exchange heat with the sub-tank 400 and the fluid accommodated therein.

The heat exchanger 300 may be energizably connected to an external power source (not shown) and the controller 500. The heat exchanger 300 may be operated by receiving electric power from an external power source (not shown). In addition, the operation of the heat exchanger 300 may be controlled according to the operation information computed by the controller 500.

The heat exchanger 300 may be provided in any form capable of exchanging heat with the sub-tank 400 and the fluid flowing therein.

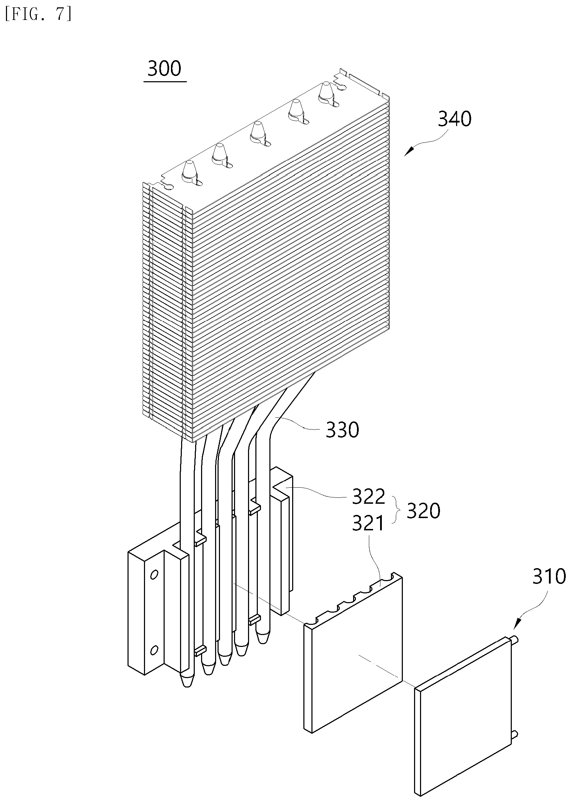

In the embodiment shown in FIG. 7, the heat exchanger 300 includes a thermoelectric element 310, a heat transfer plate 320, a heat pipe 330, a heat dissipation member 340, and a fan member 350.

The thermoelectric element 310 substantially performs the role of exchanging heat with the sub-tank 400 and the fluid flowing in the sub-tank 400. When the thermoelectric element 310 is operated, heat may be moved from the sub-tank 400 and the fluid accommodated in the sub-tank 400 toward the heat exchanger 300. Accordingly, the fluid may be cooled.

The thermoelectric element 310 is coupled to a sub-tank cover 430 of the sub-tank 400 and the heat transfer plate 320, respectively. The thermoelectric element 310 may be in contact with the sub-tank cover 430 and the heat transfer plate 320 to be heat-exchanged, respectively.

The thermoelectric element 310 may be provided in an arbitrary form capable of forming a heat flow in one direction. In an embodiment, the thermoelectric element 310 may be provided in the form of a Peltier element. In the above embodiment, the thermoelectric element 310 may be energizably connected to an external power source (not shown) or the controller 500, respectively, to be and operated.

A process in which a heat flow is formed by the thermoelectric element 310 is a well-known technology, and thus, a detailed description thereof will be omitted below.

The heat transfer plate 320 transfers the heat transferred to the thermoelectric element 310 to the heat pipe 330 and the heat dissipation member 340. The heat transfer plate 320 may be coupled to and in contact with the thermoelectric element 310 and the heat pipe 330 to exchange heat.

The heat transfer plate 320 may be formed of a material having high thermal conductivity. In an embodiment, the heat transfer plate 320 may be formed of aluminum (Al), stainless steel (SUS), copper (Cu), or an alloy thereof.

A plurality of heat transfer plates 320 may be provided. Any one of the plurality of heat transfer plates 320 may be coupled to and in contact with the thermoelectric element 310 to exchange heat. The other one of the plurality of heat transfer plates 320 may be coupled to and in contact with the one heat transfer plate 320 or the heat pipe 330 to exchange heat.

In the illustrated embodiment, the heat transfer plate 320 includes a first heat transfer plate 321 positioned between the thermoelectric element 310 and the heat pipe 330 and a second heat transfer plate 322 positioned in front of the heat pipe 330.

The first heat transfer plate 321 is coupled to the thermoelectric element 310 and the heat pipe 330 to form a portion of the heat transfer path.

In the illustrated embodiment, the rear side of the first heat transfer plate 321 is coupled to the thermoelectric element 310 to receive the heat transferred to the thermoelectric element 310. The front side of the first heat transfer plate 321 is coupled to the second heat transfer plate 322 and the heat pipe 330. Heat from the first heat transfer plate 321 may be transferred to the heat pipe 330.

In this case, the first heat transfer plate 321 may be coupled to the second heat transfer plate 322 while covering a plurality of heat pipes 330 supported by the second heat transfer plate 322. To this end, a groove partially accommodating the heat pipe 330 may be formed on one surface, that is, the front side surface, of the first heat transfer plate 321 facing the second heat transfer plate 322.

The second heat transfer plate 322 is coupled to the first heat transfer plate 321 and the heat pipe 330 to form another portion of the heat transfer path.

In the illustrated embodiment, the front side of the second heat transfer plate 322 is coupled to the first heat transfer plate 321 and the heat pipe 330. The heat transferred to the first heat transfer plate 321 may pass through the second heat transfer plate 322 or may be directly transferred to the heat pipe 330.

A groove partially accommodating the heat pipe 330 may be formed on one surface, that is, the rear side surface, of the second heat transfer plate 322 facing the first heat transfer plate 321.

In an embodiment, the heat transfer plate 320 may be coupled to the thermoelectric element 310 and the heat pipe 330, respectively, to couple the thermoelectric element 310 and the heat pipe 330. In the above embodiment, the first heat transfer plate 321 may mediate heat transfer between the thermoelectric element 310 and the heat pipe 330 as in the above-described embodiment. In this case, the first heat transfer plate 321 may be integrally formed with the heat pipe 330 and the heat dissipation member 340.

In addition, in the above embodiment, the second heat transfer plate 322 may be coupled to the first heat transfer plate 321 or the heat pipe 330 to support them, but may not be heat-exchanged therewith. In the above embodiment, the second heat transfer plate 332 may be formed of a material having low thermal conductivity, such as a synthetic resin.

The heat pipe 330 is coupled to the heat transfer plate 320 and the heat dissipation member 340, respectively. Heat from the heat transfer plate 320 may be transferred to the heat dissipation member 340 through the heat pipe 330. That is, the heat pipe 330 mediates heat transfer between the heat transfer plate 320 and the heat dissipation member 340.

The heat pipe 330 may be formed of a material having high thermal conductivity. In an embodiment, the heat pipe 330 may be formed of aluminum, stainless steel, copper, or an alloy thereof.

A plurality of heat pipes 330 may be provided. The plurality of heat pipes 330 may be spaced apart from each other and coupled to the heat transfer plate 320 and the heat dissipation member 340, respectively. In the illustrated embodiment, five heat pipes 330 are provided and are spaced apart from each other in the left-right direction.

The heat dissipation member 340 is configured to receive heat from the heat transfer plate 320 by exchanging heat with the heat transfer plate 320. The heat dissipation member 340 may be configured to discharge the received heat to the outside of the heat exchanger 300. A fan member 350 may be provided adjacent to the heat dissipation member 340 so that heat is smoothly discharged (see FIG. 12).

The heat dissipation member 340 may be provided in any form capable of dissipating the transferred heat. In the illustrated embodiment, the heat dissipation member 340 is configured to include a plurality of fin members laminated to be spaced apart in the height direction, that is, the up-down direction.

Referring to FIG. 12, the heat exchanger 300 may further include a fan member 350. The fan member 350 is configured to quickly discharge heat transferred to the heat dissipation member 340 to the outside.

The fan member 350 may be provided in any form capable of cooling the heat dissipation member 340 to discharge the transferred heat to the outside. In an embodiment, the fan member 350 may be provided in the form of a fan.

The fan member 350 is electrically conducted to the controller 500. The operation of the fan member 350 may be controlled according to the operation information computed by the controller 500.

In the cooling device 10 according to an exemplary embodiment of the present invention, the operation of the thermoelectric element 310 or the fan member 350 may be automatically controlled according to conditions. Accordingly, when the fluid is not frequently discharged, the operation of the thermoelectric element 310 or the fan member 350 is stopped, thereby improving power efficiency.

Furthermore, the fan member 350 generating noise may be operated in conjunction with the use state of the water purifier 1. Accordingly, noise generated when the fluid is not frequently discharged, such as in a late nighttime zone, may be minimized. This will be described later in detail.

The sub-tank 400 receives the fluid transferred to the main tank 100. The sub-tank 400 is coupled to the heat exchanger 300, so that the fluid introduced into the sub-tank 400 may be cooled by the heat exchanger 300. The cooled fluid may be introduced back into the main tank 100 and stored therein.

That is, the sub-tank 400 forms a circulation flow path through which fluid flows and is cooled together with the main tank 100.

The sub-tank 400 communicates with the main tank 100. Specifically, the sub-tank 400 communicates with the main tank 100 through the coupling frame 200. The fluid introduced into the main tank space 120 may flow out into the sub-tank space 420 through the frame communication hole 213 and the tank communication part 230. Similarly, the fluid cooled in the sub-tank space 420 may flow out into the main tank space 120 through the frame communication hole 213 and the tank communication part 230.

The sub-tank 400 is coupled to the coupling frame 200. Some components of the sub-tank 400 are supported by the tank coupling part 220. Other components of the sub-tank 400 are coupled to and communicate with the tank communication part 230.

The sub-tank 400 is coupled to the heat exchanger 300. Among each side of the sub-tank 400, one side toward the heat exchanger 300, that is, the front side in the illustrated embodiment, is coupled to the thermoelectric element 310 of the heat exchanger 300. Heat from the sub-tank 400 and the fluid flowing therein may be transferred to the thermoelectric element 310 to cool the fluid.

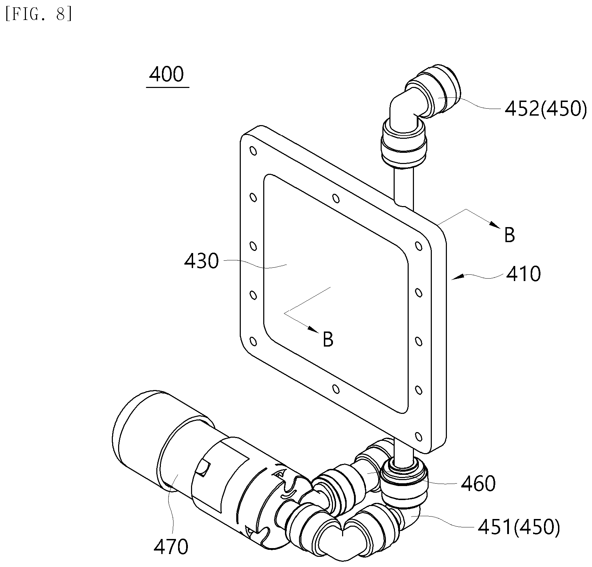

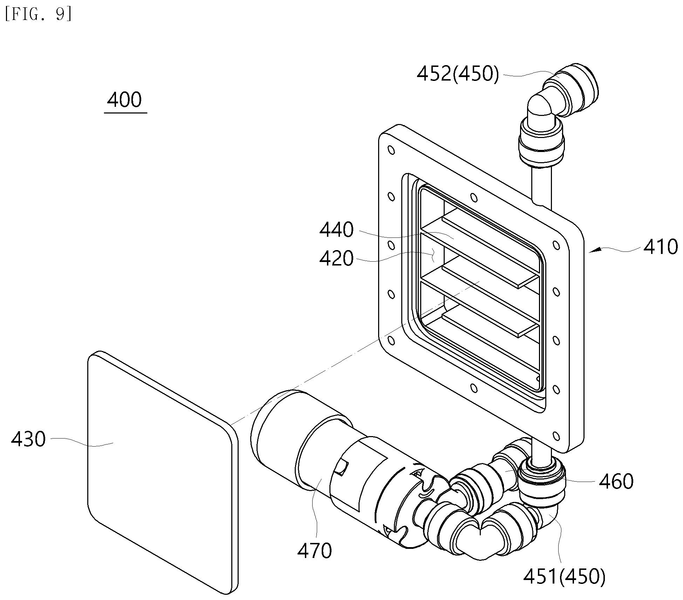

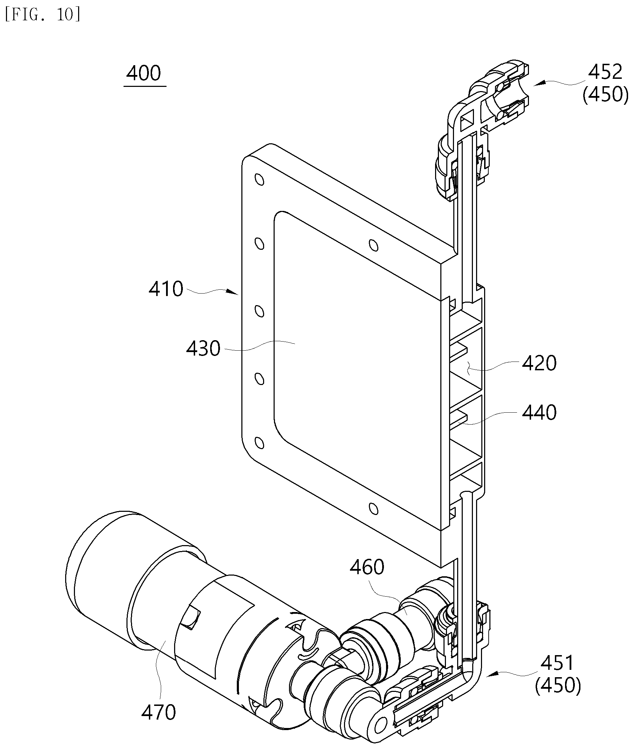

In the embodiments shown in FIGS. 8 to 10, the sub-tank 400 includes a sub-tank body 410, a sub-tank space 420, a sub-tank cover 430, a sub-partition wall member 440, a sub-communication part 450, a tank flow passage part 460, and a pump member 470.

The sub-tank body 410 forms an outer shape of the sub-tank 400. A space (i.e., a sub-tank space 420 to be described later) is formed inside the sub-tank body 410. The space is fluidly connected to the main tank space 120, so that filtered fluid may be introduced into therein or cooled fluid may flow out therefrom.

The sub-tank body 410 is coupled to the coupling frame 200. The sub-tank body 410 is accommodated in the sub-tank accommodation part 221. The outside of the sub-tank body 410, that is, in the illustrated embodiment, the upper side, lower side, left side, and right side may be supported by a plurality of plates constituting the tank coupling part 220.

The sub-tank body 410 is coupled to the sub-tank cover 430. The sub-tank space 420 formed inside the sub-tank body 410 may be sealed by the sub-tank cover 430.

The sub-tank body 410 is coupled to the thermoelectric element 310. Specifically, the sub-tank body 410 is coupled to the thermoelectric element 310 by the sub-tank cover 430.

The sub-tank body 410 is coupled to the sub-communication part 450 and the tank flow passage part 460. In the illustrated embodiment, in the case of each edge in the height direction of the sub-tank body 410, the upper edge is coupled to the sub-communication part 450 and the lower edge is coupled to the tank flow passage part 460.

The sub-tank body 410 may have an arbitrary shape capable of being coupled to the coupling frame 200 and the heat exchanger 300, respectively, and having a sub-tank space 420 formed therein. In the illustrated embodiment, the sub-tank body 410 is formed in a polygonal plate shape having a height in the up-down direction, a width in the left-right direction, and a thickness in the front-rear direction, corresponding to the shape of the tank coupling part 220.

In this case, the sub-tank body 410 may be formed to have a size smaller than that of the main tank body 110. Accordingly, as described above, the volume of the sub-tank space 420 formed inside the sub-tank body 410 is smaller than that of the main tank space 120 formed inside the main tank body 110.

Accordingly, the volume of the fluid to be cooled by the heat exchanger 300 is reduced, and thus the amount of power consumed by the heat exchanger 300 may be reduced. In addition, after a small volume of fluid is cooled, it circulates between the sub-tank space 420 and the main tank space 120, which may improve the cooling rate and cooling efficiency of the fluid.

The sub-tank body 410 may be formed of an insulating or heat-retaining material. This is to prevent a situation in which the fluid stored in the main tank space 120 is heated or cooled by heat exchange with the outside. In an embodiment, the sub-tank body 410 may be formed of a synthetic resin material. In another embodiment, the sub-tank body 410 may be surrounded by an insulating material such as foamed Styrofoam.

The sub-tank space 420 is a space formed inside the sub-tank body 410. The sub-tank space 420 communicates with the main tank space 120 to receive the fluid introduced into the main tank space 120. The fluid introduced into the sub-tank space 420 may be cooled by the heat exchanger 300 and then transferred back to the main tank space 120.

The sub-tank space 420 is fluidly connected to the sub-communication part 450 and the tank flow passage part 460. The sub-tank space 420 communicates with the main tank space 120 through the sub-communication part 450 and the tank flow passage part 460.

The sub-tank space 420 may have a shape corresponding to the shape of the sub-tank body 410. In the illustrated embodiment, the sub-tank space 420 is a polygonal pillar-shaped space having a width in the left-right direction, a height in the up-down direction, and a depth in the front-rear direction.

The sub-tank space 420 is partially surrounded by the inner circumference of the sub-tank body 410. Among each side of the sub-tank space 420, one side toward the heat exchanger 300, that is, the front side in the illustrated embodiment, is closed by the sub-tank cover 430. The sub-tank space 420 is sealed by the sub-tank cover 430.

The sub-tank cover 430 is coupled to the sub-tank body 410 to close the sub-tank space 420. The sub-tank cover 430 may be coupled to the heat exchanger 300 to receive heat from the fluid flowing in the sub-tank space 420.

The sub-tank cover 430 may be formed to correspond to the shape of the sub-tank space 420. In the illustrated embodiment, the sub-tank cover 430 is formed in a polygonal plate shape having a width in the left-right direction, a height in the up-down direction, and a thickness in the front-rear direction.

The sub-tank cover 430 may be formed of a material having high thermal conductivity. In an embodiment, the sub-tank cover 430 may be formed of aluminum, stainless steel, copper, or an alloy thereof.

Accordingly, heat exchange between the fluid flowing in the sub-tank space 420 sealed by the sub-tank cover 430 and the thermoelectric element 310 may proceed smoothly. As a result, the fluid can be effectively cooled.

The sub-partition wall member 440 divides the sub-tank space 420 into a plurality of small spaces communicating with each other. The sub-partition wall member 440 is disposed inside the sub-tank space 420.

The sub-partition wall member 440 extends from the inner surface of the sub-tank body 410 surrounding the sub-tank space 420. In the illustrated embodiment, the sub-partition wall member 440 extends from the left inner surface or the right inner surface of the sub-tank body 410.

The sub-partition wall member 440 may have an arbitrary shape capable of dividing the sub-tank space 420 into a plurality of small spaces. In the illustrated embodiment, the sub-partition wall member 440 is provided in a plate shape having a length in the left-right direction, a thickness in the up-down direction, and a width in the front-rear direction.

In this case, the length in the left-right direction of the sub-partition wall member 440 may be shorter than that in the left-right direction of the sub-tank space 420. Accordingly, one end in the extension direction of the sub-partition wall member 440 is spaced apart from the inner surface of the sub-tank body 410 to form a space therebetween. Through the space, the plurality of partitioned small spaces may communicate with each other.

In this case, the width in the front-rear direction of the sub-partition wall member 440 may be the same as the depth in the front-rear direction of the sub-tank space 420. That is, each edge in the width direction of the sub-partition wall member 440 is in contact with the rear side surface of the sub-tank body 410 and the sub-tank cover 430, respectively. Therefore, the fluid flowing along the sub-partition wall member 440 in one small space may be introduced into another small space only through the above space.

A plurality of sub-partition wall members 440 may be formed. The plurality of sub-partition wall members 440 may be spaced apart from each other in the height direction of the sub-tank space 420, that is, in the up-down direction in the illustrated embodiment. In this case, the sub-partition wall members 440 adjacent to each other may extend from different surfaces of the inner surface of the sub-tank body 410.

Therefore, the fluid flowing in the sub-tank space 420 may flow along a zigzag-shaped flow path along the sub-partition wall members 440 alternately arranged with each other.

The sub-communication part 450 is coupled to the sub-tank body 410 to communicate the sub-tank space 420 with the outside. The main tank space 120 and the sub-tank space 420 may be fluidly connected to each other through the sub-communication part 450.

A plurality of sub-communication parts 450 may be provided. The plurality of sub-communication parts 450 may communicate the sub-tank space 420 with the outside at different positions. In the illustrated embodiment, the sub-communication part 450 includes a first sub-communication part 451 coupled to the lower side of the sub-tank body 410 and a second sub-communication part 452 coupled to the upper side of the sub-tank body 410.

Any one of the first sub-communication part 451 and the second sub-communication part 452 may form an inflow passage through which fluid flows into the sub-tank space 420. The other one of the first sub-communication part 451 and the second sub-communication part 452 may form an outflow passage through which fluid flows into the main tank space 120.

Any one of the first sub-communication part 451 and the second sub-communication part 452 may be coupled to and communicate with the tank communication part 230. In the illustrated embodiment, the second sub-communication part 452 located at the upper side is coupled to the first tank communication part 231 located at the upper side to communicate the sub-tank space 420 with the main tank space 120.

The other one of the first sub-communication part 451 and the second sub-communication part 452 may be coupled to and communicate with the tank flow passage part 460 and the pump member 470. In the illustrated embodiment, the first sub-communication part 451 located at the lower side is coupled to and communicates with the tank flow passage part 460 and the pump member 470, respectively.

In the above embodiment, the first sub-communication part 451 may form an inflow passage through which fluid accommodated in the main tank space 120 is introduced into the sub-tank space 420. In addition, the second sub-communication part 452 may form an outflow passage through which fluid cooled and accommodated in the sub-tank space 420 flows out into the main tank space 120.

The tank flow passage part 460 is coupled to the sub-tank body 410 through the sub-communication part 450 to communicate the sub-tank space 420 with the outside.

The tank flow passage part 460 may be coupled to and communicate with the tank communication part 230. In the illustrated embodiment, the tank flow passage part 460 is coupled to the second tank communication part 232 located at the lower side to communicate the sub-tank space 420 with the main tank space 120.

The tank flow passage part 460 is coupled to the other one of the sub-communication part 450. In the illustrated embodiment, the tank flow passage part 460 is coupled to and communicates with the first sub-communication part 451.

The tank flow passage part 460 is coupled to and communicates with the pump member 470. By the transfer force applied by the pump member 470, the fluid in the main tank space 120 may flow to the tank flow passage part 460.

The pump member 470 provides a transfer force for the fluid stored in the main tank space 120 to flow into the sub-tank space 420. The pump member 470 is coupled to and communicates with the tank flow passage part 460.

When the pump member 470 is operated, the fluid accommodated in the main tank space 120 is introduced into the sub-tank space 420. Accordingly, the fluid cooled in the sub-tank space 420 may be pushed by the incoming fluid and discharged into the main tank space 120. That is, the pump member 470 provides a transfer force for cooling and storing the fluid while circulating between the main tank 100 and the sub-tank 400.

In an embodiment, the fluid accommodated in one of the main tank 100 and the sub-tank 400 may flow toward the other only when the pump member 470 is operated. To this end, the sub-communication part 450 or the tank flow passage part 460 may be provided with a check valve or the like configured to open the flow passage by a difference in pressure.

The pump member 470 is electrically conducted to the controller 500. In addition, the operation of the pump member 470 may be controlled according to the operation information computed by the controller 500.

In an embodiment, the pump member 470 may provide a transfer force so that the fluid introduced into the sub-tank space 420 flows out of the main tank space 120 other than the main tank space 120. In the above embodiment, other fluids such as air may be accommodated in the sub-tank space 420 through which the fluid is discharged.

In the above embodiment, when the pump member 470 is operated, the fluid in the main tank space 120 may be introduced into the empty sub-tank space 420 to be filled, cooled, and then discharged back into the main tank space 120.

Referring further to FIG. 12, the cooling device 10 according to an exemplary embodiment of the present invention further includes a controller 500.

The controller 500 is energizably connected to other components of the cooling device 10 to control the operation of the other components. The controller 500 may compute operation information for controlling the operations of the other components by using detection information generated by the main temperature sensor 150.

In addition, the controller 500 may compute operation information using a control signal input from the outside. In the above embodiment, the controller 500 may further include an input module (not shown) for receiving a control signal.

The controller 500 may be provided in an arbitrary form capable of inputting, computing, and outputting information, and controlling other components. In an embodiment, the controller 500 may be provided in the form of a CPU, a microprocessor, or the like.

The controller 500 is energizably connected to the main tank 100. The controller 500 may receive detection information generated by the main temperature sensor 150.

The controller 500 is energizably connected to the heat exchanger 300. The controller 500 may control the operation of the components of the heat exchanger 300, for example, the thermoelectric element 310 and the fan member 350 according to the computed operation information.

The controller 500 is energizably connected to the sub-tank 400. The controller 500 may control the operation of the pump member 470 according to the computed operation information. Accordingly, a circulation flow path of the fluid including the main tank 100 and the sub-tank 400 may be formed or dissipated.

In the embodiment shown in FIG. 12, the controller 500 includes a state information computation module 510, an operation information computation module 520, a heat exchanger control module 530, and a pump member control module 540.

The state information computation module 510 computes state information on the operation state of the main tank 100 by using detection information generated by the main temperature sensor 150. In addition, the state information computation module 510 may compute the state information using detection information on whether fluid flows out from the main tank 100 to the water discharge module 30.

The state information computed by the state information computation module 510 is transmitted to the operation information computation module 520. The state information computation module 510 is energizably connected to the operation information computation module 520.

In the illustrated embodiment, the state information computation module 510 includes a temperature information computation unit 511 and a water discharge information computation unit 512. The state information computed by the state information computation module 510 may include temperature information and water discharge information.

The temperature information computation unit 511 computes temperature information on the temperature of the fluid accommodated in the main tank space 120 by using the detection information generated by the main temperature sensor 150. The temperature information computed by the temperature information computation unit 511 is transmitted to the operation information computation module 520.

The water discharge information computation unit 512 computes water discharge information on whether the fluid accommodated in the main tank 100 is discharged to the outside through the water discharge module 30 fluidly connected to the main tank 100. The water discharge information computed by the water discharge information computation unit 512 is transmitted to the operation information computation module 520.

In an embodiment, a water discharge sensor (not shown) for generating detection information used as a basis for computing the water discharge information by the water discharge information computation unit 512 may be provided in the main communication part 130. In the above embodiment, the water discharge sensor (not shown) may be energizably connected to the controller 500 to transmit the generated detection information to the controller 500.

The operation information computation module 520 computes operation information for controlling the components of the cooling device 10 using the computed state information. The computed operation information may include cooling information for controlling the thermoelectric element 310, heat dissipation information for controlling the fan member 350, and flow passage information for controlling the pump member 470.

The operation information computed by the operation information computation module 520 is transmitted to the heat exchanger control module 530 and the pump member control module 540. The operation information computation module 520 is energizably connected to the heat exchanger control module 530 and the pump member control module 540.

In the illustrated embodiment, the operation information computation module 520 includes a cooling information computation unit 521, a heat dissipation information computation unit 522, and a flow passage information computation unit 523.

The cooling information computation unit 521 computes cooling information for controlling the thermoelectric element 310 of the heat exchanger 300 using the computed temperature information or water discharge information. The computed cooling information may include any information related to whether the thermoelectric element 310 is operated, its operation time, its operation strength, and so on.

Specifically, the cooling information computation unit 521 compares the computed temperature information with a preset reference temperature range. In this case, the reference temperature range may be determined as a range of temperatures at which the thermoelectric element 310 does not have to be operated.

That is, the reference temperature range may be determined as a temperature range in which cooling is not necessary to continue since the fluid discharged may be recognized by a user as cold water. In an embodiment, the reference temperature range may be determined to be 6 °C to 9 °C.

If the computed temperature information falls within the preset reference temperature range, the fluid stored in the main tank 100 may be determined to be sufficiently cooled. Accordingly, the cooling information computation unit 521 computes cooling information including the content of stopping the operation of the thermoelectric element 310.

If the computed temperature information is out of the preset reference temperature range, it may be determined that the fluid stored in the main tank 100 is not sufficiently cooled. Accordingly, the cooling information computation unit 521 computes cooling information including the content of operating the thermoelectric element 310.

In addition, the cooling information computation unit 521 may compute cooling information using the computed water discharge information. Specifically, the cooling information computation unit 521 may compute cooling information by comparing the time for which the water discharge has not proceeded among the content of the computed water discharge information with a preset reference time.

If the water discharge has not proceeded beyond a preset reference time, it may be inferred to be a time zone in which the user does not use the water purifier 1, such as going out or late at night. Accordingly, the cooling information computation unit 521 computes cooling information including the content of stopping the operation of the thermoelectric element 310.

If the water discharge has not been carried out for less than a preset time, it may be inferred to be a time zone in which the water discharge has not been carried out for a considerable period of time, but may soon be carried out. Accordingly, the cooling information computation unit 521 computes cooling information including the content of operating the thermoelectric element 310.

The computed cooling information is transmitted to the heat exchanger control module 530.

The heat dissipation information computation unit 522 computes heat dissipation information for controlling the fan member 350 of the heat exchanger 300 using the computed temperature information or water discharge information. The computed heat dissipation information may include any information related to whether the fan member 350 is operated, its operation time, its operation speed, and so on.

Specifically, the heat dissipation information computation unit 522 compares the computed temperature information with preset reference temperature information.

If the computed temperature information falls within the preset reference temperature range, the fluid stored in the main tank 100 may be determined to be sufficiently cooled. Accordingly, the heat dissipation information computation unit 522 computes heat dissipation information including the content of stopping the operation of the fan member 350.

If the computed temperature information is out of the preset reference temperature range, it may be determined that the fluid stored in the main tank 100 is not sufficiently cooled. Accordingly, the heat dissipation information computation unit 522 computes heat dissipation information including the content of operating the fan member 350.

In addition, the heat dissipation information computation unit 522 may compute cooling information using the computed water discharge information.

If the water discharge has not proceeded beyond a preset reference time, the heat dissipation information computation unit 522 computes heat dissipation information including the content of stopping the operation of the fan member 350.

If the water discharge has not proceeded below the preset reference time, the heat dissipation information computation unit 522 computes heat dissipation information including the content of operating the fan member 350.

Meanwhile, the heat dissipation information computation unit 522 may compute heat dissipation information using the computed cooling information. That is, when the thermoelectric element 310 is operated, it is preferable that the fan member 350 is also operated to dissipate generated heat.

Accordingly, if the cooling information computed by the cooling information computation unit 521 includes the content of operating the thermoelectric element 310, the heat dissipation information computation unit 522 may compute heat dissipation information including the content of operating the fan member 350.

Similarly, if the cooling information computed by the cooling information computation unit 521 includes the content of stopping the operation of the thermoelectric element 310, the heat dissipation information computation unit 522 may compute heat dissipation information including the content of stopping the operation of the fan member 350.

The computed heat dissipation information is transmitted to the heat exchanger control module 530.

The flow passage information computation unit 523 computes flow passage information for controlling the pump member 470 of the sub-tank 400 using the computed temperature information or water discharge information. The computed flow passage information may include any information related to whether the pump member 470 is operated, its operation time, its operation speed, and so on.

Specifically, the flow passage information computation unit 523 compares the computed temperature information with a preset reference temperature range.

If the computed temperature information falls within the preset reference temperature range, the fluid stored in the main tank 100 may be determined to be sufficiently cooled. Accordingly, the flow passage information computation unit 523 computes flow passage information including the content of stopping the operation of the pump member 470.

If the computed temperature information is out of a preset reference temperature range, the flow passage information computation unit 523 computes flow passage information including the content of operating the pump member 470.

In addition, the flow passage information computation unit 523 may compute flow passage information using the computed water discharge information.

If the water discharge has not proceeded beyond a preset reference time, the flow passage information computation unit 523 computes flow passage information including the content of stopping the operation of the pump member 470.

If the water discharge has not proceeded below the preset reference time, the flow passage information computation unit 523 computes flow passage information including the content of operating the pump member 470.

Meanwhile, if the computed flow passage information includes the content of operating the pump member 470, the flow passage information computation unit 523 may further compute timing information on the operation timing of the thermoelectric element 310 or the fan member 350.

That is, if the thermoelectric element 310, the fan member 350, and the pump member 470 are stopped for a predetermined time, the temperature of the fluid accommodated in the sub-tank 400 may increase. In the above state, if the thermoelectric element 310, the fan member 350, and the pump member 470 operate at the same time, there is a concern that the fluid whose temperature has increased is introduced into the main tank 100, and the temperature of the fluid accommodated in the main tank 100 may increase.

Accordingly, the flow passage information computation unit 523 computes timing information on the operation timing of the thermoelectric element 310 or the fan member 350. In addition, the flow passage information computation unit 523 may compute flow passage information so that the pump member 470 operates after a preset time has elapsed from the computed timing information.

Accordingly, the fluid accommodated in the sub-tank 400 may be cooled and then introduced into the main tank 100, thereby preventing an increase in the temperature of the fluid accommodated in the main tank 100.

The computed flow passage information is transmitted to the pump member control module 540.

Meanwhile, the operation information computation module 520 may perform a computation of changing a preset reference temperature range based on the water discharge information. In this case, the reference time may be defined as a first reference time. If the time when the fluid is not discharged to the outside through the water discharge module 30 exceeds a preset second reference time longer than the first reference time, the user may be expected to be in a sleeping state.

Usually, users immediately after waking up generally want to drink purified water at room temperature or slightly lower than room temperature than cooled cold water. Therefore, if the outflow of the fluid has not proceeded for the second reference time, the operation information computation module 520 may compute the reference temperature range so that the upper limit thereof is increased.

The heat exchanger control module 530 controls the components of the heat exchanger 300 according to the computed operation information. The heat exchanger control module 530 is energizably connected to the components of the heat exchanger 300.

In the illustrated embodiment, the heat exchanger control module 530 includes a thermoelectric element control unit 531 and a fan member control unit 532.

The thermoelectric element control unit 531 controls the operation of the thermoelectric element 310 according to the computed cooling information. The thermoelectric element control unit 531 may control whether the thermoelectric element 310 is operated, its operation time, its operation strength, and so on.

The fan member control unit 532 controls the operation of the fan member 350 according to the computed heat dissipation information. The fan member control unit 532 may control whether the fan member 350 is operated, its operation time, its operation speed, and so on.

The pump member control module 540 controls the operation of the pump member 470 according to the computed flow passage information. The pump member control module 540 is energizably coupled to the pump member 470.

The pump member control module 540 may control whether the pump member 470 is operated, its operation time, its operation speed, and so on.

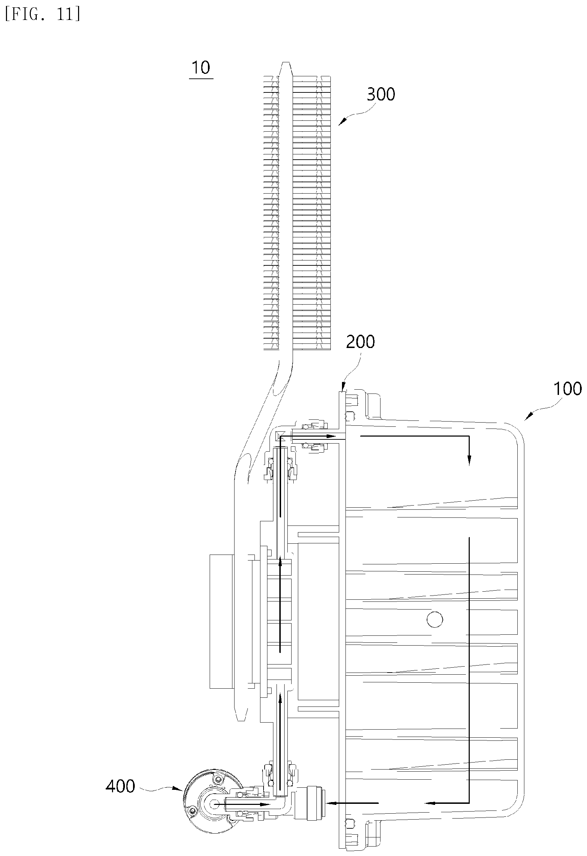

Referring to FIG. 11, a fluid circulation flow passage formed inside the cooling device 10 according to an exemplary embodiment of the present invention is shown as an example.

The fluid passing through the filtration module 20 is introduced into the main tank space 120 through the main communication part 130. In an embodiment, since the first main communication part 131 fluidly connected to the filtration module 20 is located at the upper side, the filtered fluid is introduced into the upper side of the main tank space 120 and is moved downward.

When the heat exchanger 300 and the pump member 470 operate, the main tank space 120 and the sub-tank space 420 communicate with each other and the filtered fluid is discharged into the sub-tank space 420. In this case, since the main tank space 120 and the sub-tank space 420 are fluidly connected through the tank flow passage part 460 located below, the fluid stored at the lower side of the main tank space 120 is discharged into the sub-tank space 420.

The fluid is introduced into the sub-tank space 420 through the first sub-communication part 451 located at the lower side, cooled, and then discharged through the second sub-communication part 452 located at the upper side. Since the second sub-communication part 452 communicates with the upper side of the main tank space 120, the cooled fluid is introduced into the upper side of the main tank space 120.

As the above process is repeated, the temperature of the fluid stored in the main tank space 120 may decrease. In this case, since the cooled fluid is introduced into the upper side of the main tank space 120, the interference of convection by the main partition wall member 140 may be minimized. Accordingly, the temperature of the fluid stored in the main tank space 120 may be maintained in a lowered state.

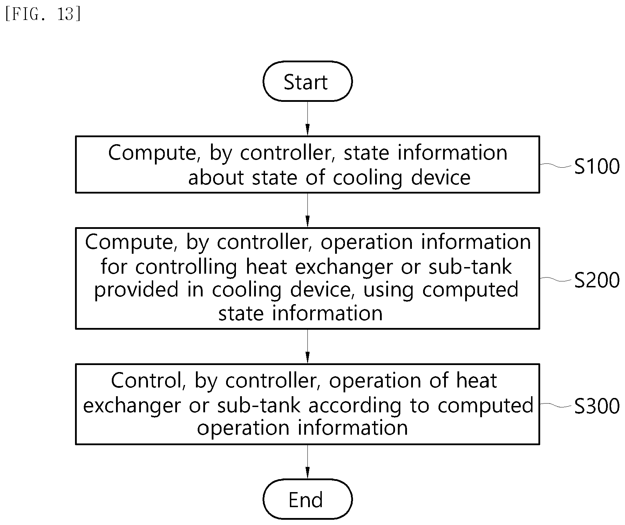

Referring to FIGS. 13 to 20, a flow of a control method of the cooling device 10 according to an exemplary embodiment of the present invention is illustrated. The control method of cooling device 10 according to the illustrated embodiment may be performed by the above-described configuration.

In the embodiment shown in FIG. 13, the control method for the cooling device 10 includes computing, by the controller 500, state information about the state of the cooling device 10 (S100); computing, by the controller 500, operation information for controlling the heat exchanger 300 or the sub-tank 400 provided in the cooling device 10, using the computed state information (S200); controlling, by the controller 500, the operation of the heat exchanger 300 or the sub-tank 400 according to the computed operation information (S300).

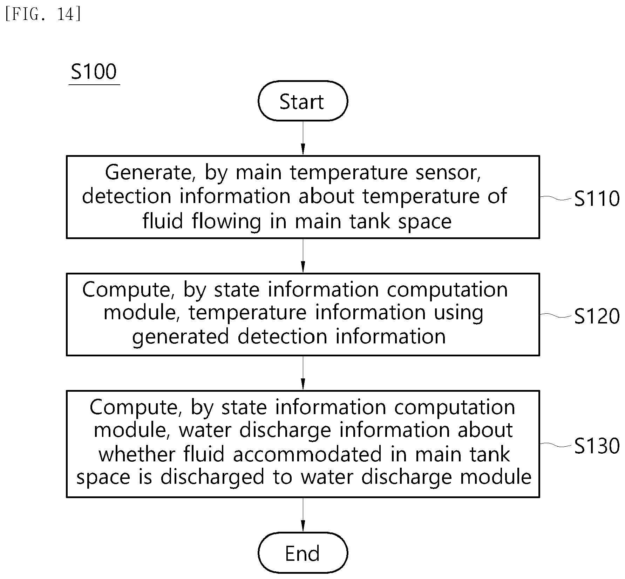

Referring to FIG. 14, a detailed flow of step S100 of computing, by the controller 500, state information about the state of the cooling device 10 is illustrated. This step S100 is a step S100 of computing, by the state information computation module 510, state information about the state of the main tank 100 using detection information generated by the main temperature sensor 150.

The main temperature sensor 150 generates detection information about the temperature of the fluid flowing in the main tank space 120 (S110). The generated detection information is transmitted to the state information computation module 510.

The state information computation module 510 computes temperature information about the temperature of the fluid flowing inside the main tank space 120 using the generated detection information (S120).

In addition, the state information computation module 510 computes water discharge information about whether the fluid accommodated in the main tank space 120 is discharged to the water discharge module 30 (S130). As described above, the state information computation module 510 may compute the water discharge information using the detection information generated by the water discharge sensor (not shown).

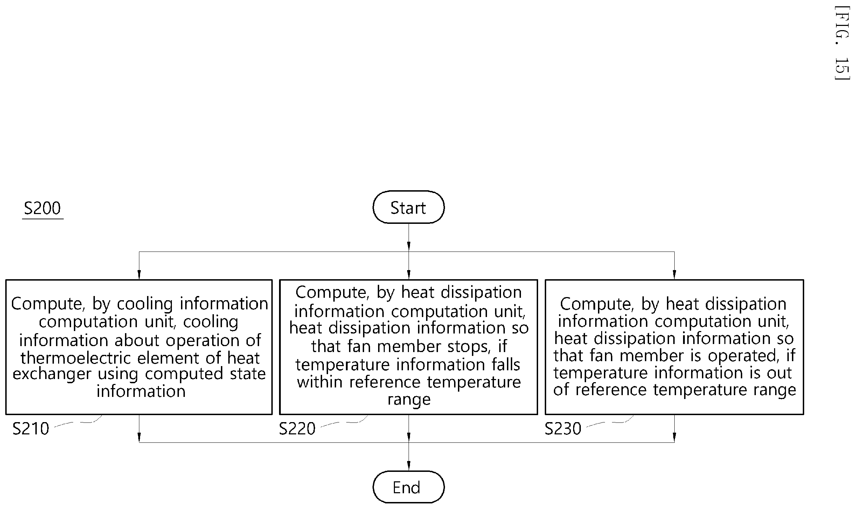

Referring to FIGS. 15 to 19, a detailed flow of step S200 of computing, by the controller 500, operation information for controlling the heat exchanger 300 or sub-tank 400 provided in the cooling device 10 using the computed state information is illustrated. This step S200 is a step S200 of computing, by the operation information computation module 520, operation information for controlling the heat exchanger 300 or the sub-tank 400 using the computed state information.

The cooling information computation unit 521 computes cooling information about the operation of the thermoelectric element 310 of the heat exchanger 300 using the temperature information among the computed state information (S210). The cooling information computed in this step S210 may differ depending on the computed temperature information.

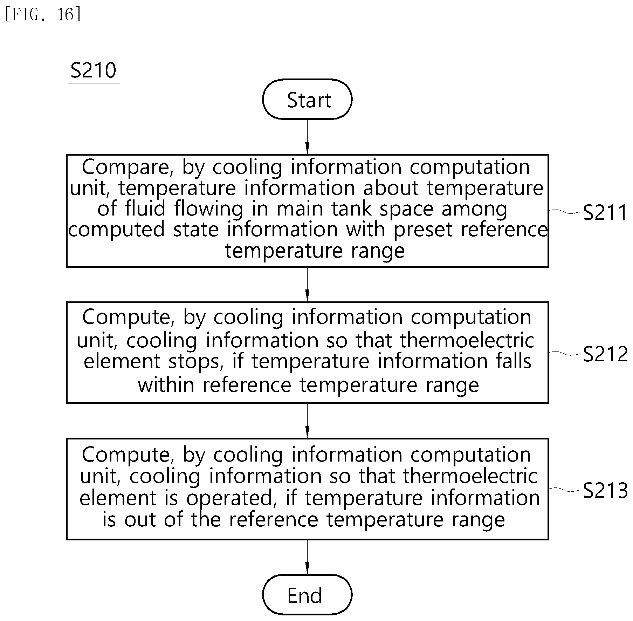

That is, as shown in FIG. 16, the cooling information computation unit 521 compares the temperature information about the temperature of the fluid flowing in the main tank space 120 among the computed state information with a preset reference temperature range (S211).

If the computed temperature information falls within the reference temperature range, the cooling information computation unit 521 computes the cooling information so that the thermoelectric element 310 stops (S212). If the computed temperature information is out of the reference temperature range, the cooling information computation unit 521 computes the cooling information so that the thermoelectric element 310 is operated (S213).

In addition, the heat dissipation information computation unit 522 computes heat dissipation information about the operation of the fan member 350 of the heat exchanger 300 using the temperature information among the computed state information (S220). The heat dissipation information computed in this step S220 may differ depending on the computed temperature information.

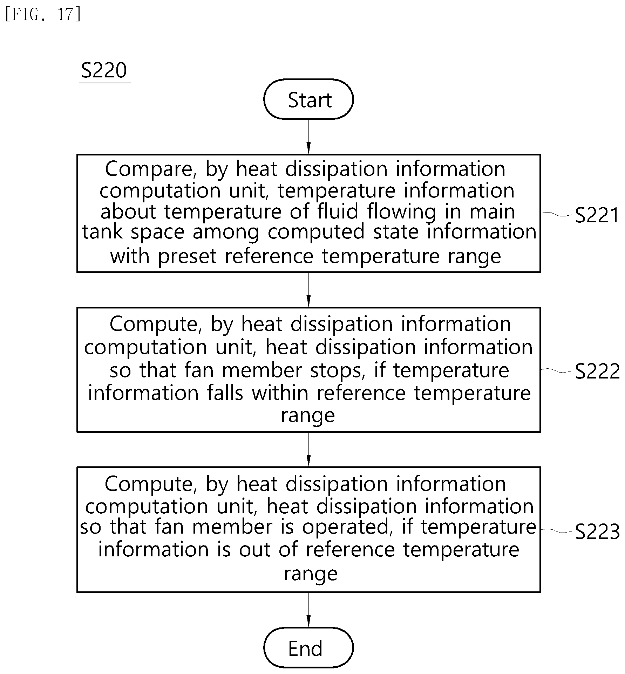

That is, as shown in FIG. 17, the heat dissipation information computation unit 522 compares the temperature information about the temperature of the fluid flowing in the main tank space 120 among the computed state information with a preset reference temperature range (S221).

If the computed temperature information falls within the reference temperature range, the heat dissipation information computation unit 522 computes the heat dissipation information so that the fan member 350 stops (S222). If the computed temperature information is out of the reference temperature range, the heat dissipation information computation unit 522 computes the heat dissipation information so that the fan member 350 is operated (S223).

Furthermore, the flow passage information computation unit 523 computes flow passage information about the operation of the pump member 470 of the sub-tank 400 using the computed state information (S230). The flow passage information computed in this step S230 may differ depending on the computed temperature information.

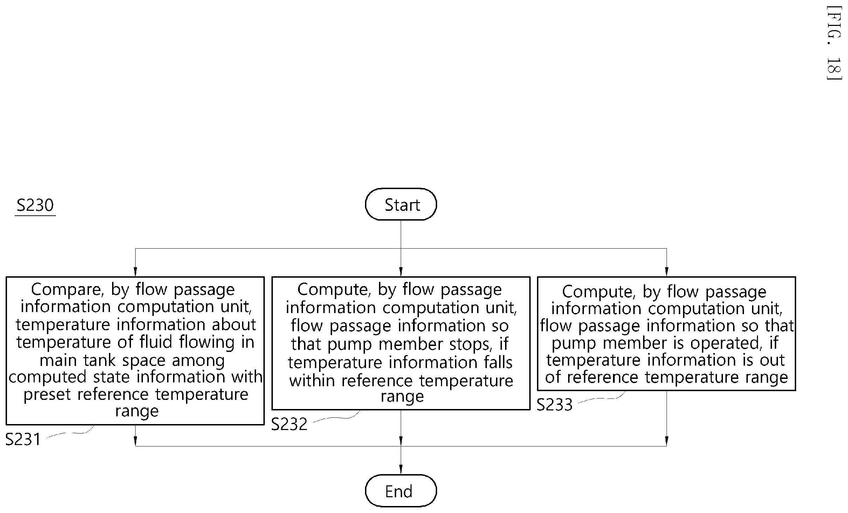

That is, as shown in FIG. 18, the flow passage information computation unit 523 compares the temperature information about the temperature of the fluid flowing in the main tank space 120 among the computed state information with a preset reference temperature range (S231).

If the computed temperature information falls within the reference temperature range, the flow passage information computation unit 523 computes the flow passage information so that the pump member 470 stops (S232). If the computed temperature information is out of the reference temperature range, the flow passage information computation unit 523 computes the flow passage information so that the pump member 470 is operated (S233).

If the flow passage information computation unit 523 computes the flow passage information so that the pump member 470 operates, the flow passage information computation unit 523 may further compute timing information on the operation timing of the thermoelectric element 310 or the fan member 350.

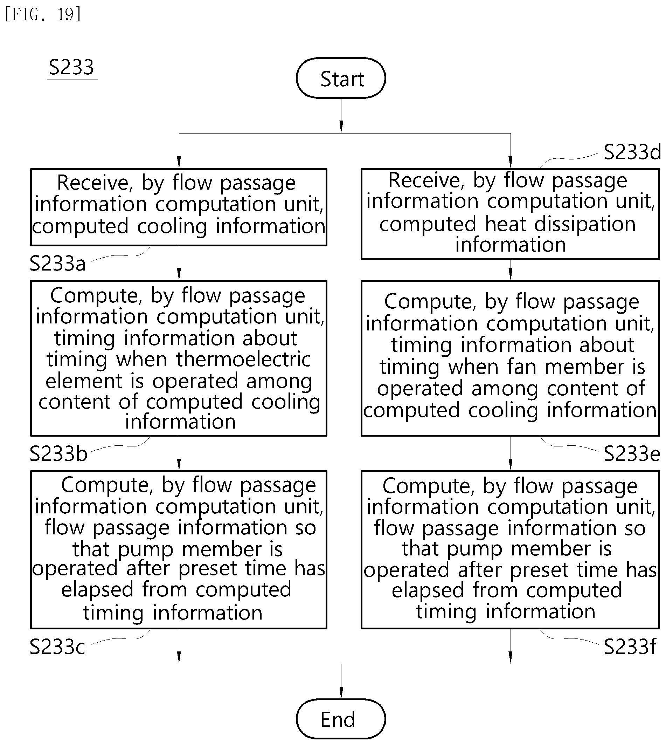

That is, as shown in FIG. 19, the flow passage information computation unit 523 receives the computed cooling information (S233a). The flow passage information computation unit 523 computes timing information about timing when the thermoelectric element 310 is operated among the content of the computed cooling information (S233b). The flow passage information computation unit 523 computes the flow passage information so that the pump member 470 operates after a preset time has elapsed from the computed timing information (S233c).

That is, in these steps S233a, S233b, and S233c, the flow passage information computation unit 523 computes flow passage information computation unit so that the pump member 470 operates after a preset time has elapsed after the thermoelectric element 310 operates.

In addition, the flow passage information computation unit 523 receives the computed heat dissipation information (S233d). The flow passage information computation unit 523 computes timing information about timing when the fan member 350 is operated among the content of the computed cooling information (S233e). The flow passage information computation unit 523 computes the flow passage information so that the pump member 470 operates after a preset time has elapsed from the computed timing information (S233f).

That is, in these steps S233d, S233e, and S233f, the flow passage information computation unit 523 computes flow passage information computation unit so that the pump member 470 operates after a preset time has elapsed after the fan member 350 operates.

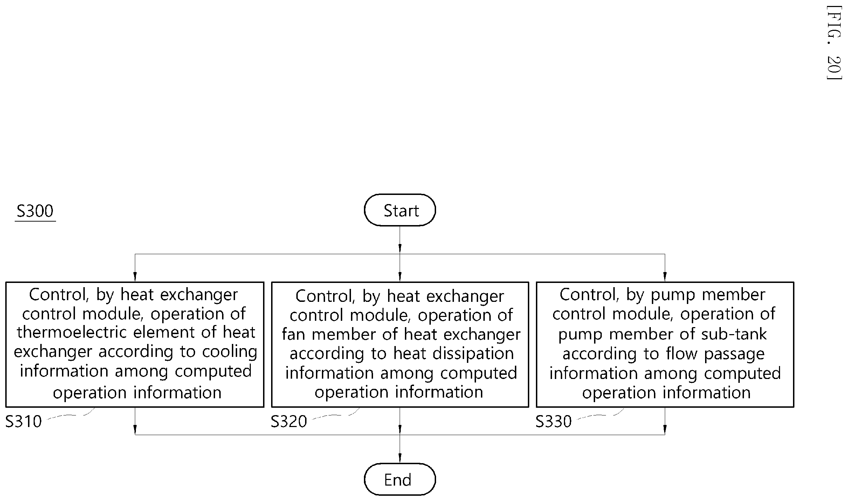

Referring to FIG. 20, a detailed flow of step S300 of controlling, by the controller 500, the operation of the heat exchanger 300 or the sub-tank 400 according to the computed operation information is illustrated. This step S300 is a step S300 of controlling, by the heat exchanger control module 530 or the pump member control module 540, the thermoelectric element 310, the fan member 350, or the pump member 470.

The thermoelectric element control unit 531 of the heat exchanger control module 530 controls the operation of the thermoelectric element 310 of the heat exchanger 300 according to the cooling information among the computed operation information (S310). The fan member control unit 532 of the heat exchanger control module 530 controls the operation of the fan member 350 of the heat exchanger 300 according to the heat dissipation information among the computed operation information (S320). The pump member control module 540 controls the operation of the pump member 470 of the sub-tank 400 according to the flow passage information among the computed operation information (S330).

Although not shown, the operation information computation module 520 may compute operation information using the computed water discharge information as described above.

Although exemplary embodiments of the present invention have been described, the idea of the present invention is not limited to the embodiments set forth herein. Those of ordinary skill in the art who understand the idea of the present invention may easily propose other embodiments through supplement, change, removal, addition, etc. of elements within the same idea, but the embodiments will be also within the scope of the present invention.

| | | | | |
|---|---|---|---|---|
| 1: | water purifier | 10: | cooling device | |
| 20: | filtration module | 30: | water discharge module | |
| 100: | main tank | 110: | main tank body | |
| 120: | main tank space | 130: | main communication part | |
| 131: | first main communication part | 132: | second main | |
| | | | | communication part |
| | 140: | main partition wall member | 150: | main temperature sensor |
| | 200: | coupling frame | 210: | frame body |
| | 211: | first frame surface | 212: | second frame surface |
| | 213: | frame communication hole | 213a: | first frame communication hole |
| | 213b: | second frame communication hole | 220: | tank coupling part |
| | 221: | sub-tank accommodation part | 230: | tank communication part |
| | 231: | first tank communication part | 232: | second tank communication part |
| | 240: | sealing member | 300: | heat exchanger |
| | 310: | thermoelectric element | 320: | heat transfer plate |
| | 321: | first heat transfer plate | 322: | second heat transfer plate |
| | 330: | heat pipe | 340: | heat dissipation member |
| | 350: | fan member | 400: | sub-tank |
| | 410: | sub-tank body | 420: | sub-tank space |
| | 430: | sub-tank cover | 440: | sub-partition wall member |
| | 450: | sub-communication part | 451: | first sub-communication part |
| | 452: | second sub-communication part | 460: | tank flow passage part |
| | 470: | pump member | 500: | controller |
| | 510: | state information computation module | 511: | temperature information computation unit |
| | 512: | water discharge information computation unit | 520: | operation information computation module |
| | 521: | cooling information computation unit | 522: | heat dissipation information computation unit |
| | 523: | flow passage information computation unit | 530: | heat exchanger control module |
| | 531: | thermoelectric element control unit | 532: | fan member control unit |
| | 540: | pump member control module | | |

## Claims

1. A cooling device, comprising:
a main tank fluidly connected to the outside thereof to receive a fluid, store the received fluid, and deliver the stored fluid to the outside;
a heat exchanger positioned adjacent to the main tank to cool the received fluid; and
a sub-tank which is fluidly connected to the main tank to receive the fluid that has been delivered to the main tank and which is coupled to the heat exchanger to cool the received fluid,
wherein the fluid introduced into the main tank is cooled by the heat exchanger while passing through the sub-tank and then is introduced back to the main tank.

2. The cooling device of claim 1,
wherein the sub-tank comprises:
a sub-tank body coupled to the main tank and having a sub-tank space formed therein that is fluidly connected to the main tank; and
a sub-tank cover covering the sub-tank space and coupled to the sub-tank body, and coupled to the heat exchanger to exchange heat with the heat exchanger.

3. The cooling device of claim 2,
wherein the sub-tank comprises:
a tank flow passage part coupled to the sub-tank body and fluidly connected to the sub-tank space and the main tank space of the main tank, respectively; and
a pump member fluidly connected to the tank flow passage part and configured to provide a transfer force so that the fluid accommodated in the main tank space flows to the sub-tank space.

4. The cooling device of claim 3,
wherein the sub-tank comprises:
a first sub-communication part fluidly connected to the pump member and the sub-tank space, respectively, to form a flow passage through which the fluid is introduced into the sub-tank space; and
a second sub-communication part fluidly connected to the sub-tank space and the main tank space, respectively, to form a flow passage through which the cooled fluid is discharged from the sub-tank space to the main tank space.

5. The cooling device of claim 4,
wherein the sub-tank body extends along one direction,
wherein the first sub-communication part, the tank flow passage part, and the pump member are positioned adjacent to one end in the extension direction of the sub-tank body, and
wherein the second sub-communication part is positioned adjacent to the other end in the extension direction of the sub-tank body.

6. The cooling device of claim 2,
wherein the sub-tank cover is formed of a material having a higher thermal conductivity than the material of the main tank and the material of the sub-tank body.

7. The cooling device of claim 6,
wherein the sub-tank cover is made of a material including copper (Cu), aluminum (Al), or stainless steel, and
wherein the main tank and the sub-tank body are formed of a synthetic resin material.

8. The cooling device of claim 1, further comprising a controller electrically connected to the heat exchanger and the sub-tank to control the operation of the heat exchanger and the sub-tank.

9. The cooling device of claim 8,
wherein the main tank comprises:
a main tank space formed therein and fluidly connected to the outside and the sub-tank; and
a main temperature sensor coupled to the main tank to generate detection information about the fluid flowing in the main tank space, and
wherein the controller is electrically connected to the main temperature sensor to receive the generated detection information.

10. The cooling device of claim 9,
wherein the heat exchanger comprises:
a thermoelectric element coupled to the sub-tank to exchange heat with the sub-tank and fluid introduced into the sub-tank; and
a fan member coupled to the thermoelectric element to emit heat transferred to the thermoelectric element, and
wherein the controller is configured to compute operation information for controlling the operation of the thermoelectric element and the fan member using the detection information.

11. The cooling device of claim 9,
wherein the sub-tank comprises:
a pump member fluidly connected to a sub-tank space formed inside the sub-tank and a main tank space formed inside the main tank, respectively, so that the fluid introduced into the main tank is discharged to the sub-tank, and
wherein the controller is configured to compute operation information for controlling the operation of the pump member using the detection information.

12. A control method for a cooling device, the control method comprising:
(a) computing, by a controller, state information about a state of a cooling device;
(b) computing, by the controller, operation information for controlling a heat exchanger or a sub-tank provided in the cooling device using the computed state information; and
(c) controlling, by the controller, the operation of the heat exchanger or the sub-tank according to the computed operation information.

13. The control method for a cooling device of claim 12,
wherein the step (a) comprises:
(a1) generating, by a main temperature sensor, detection information about the temperature fluid flowing inside a main tank space;
(a2) computing, by a state information computation module, temperature information using the generated detection information; and
(a3) computing, by the state information computation module, water discharge information about whether fluid accommodated in the main tank space is discharged to a water discharge module.

14. The control method for a cooling device of claim 12,
wherein the step (b) comprises:
(b1) computing, by a cooling information computation unit, cooling information about the operation of a thermoelectric element of the heat exchanger using the computed state information;
(b2) computing, by a heat dissipation information computation unit, heat dissipation information about the operation of a fan member of the heat exchanger using the computed state information; and
(b3) computing, by a flow passage information computation unit, flow passage information about the operation of a pump member of the sub-tank using the computed state information.

15. The control method for a cooling device of claim 14,
wherein the step (b1) comprises:
(b11) comparing, by the cooling information computation unit, temperature information about the temperature of fluid flowing in a main tank space among the computed state information with a preset reference temperature range;
(b12) computing, by the cooling information computation unit, the cooling information so that the thermoelectric element stops, if the temperature information falls within the reference temperature range; and
(b13) computing, by the cooling information computation unit, the cooling information so that the thermoelectric element stops, if the computed temperature information is out of the reference temperature range.

16. The control method for a cooling device of claim 14,
wherein the step (b2) comprises:
(b21) comparing, by the heat dissipation information computation unit, temperature information about the temperature of fluid flowing in a main tank space among the computed state information with a preset reference temperature range;
(b22) computing, by the heat dissipation information computation unit, the heat dissipation information so that the fan member stops, if the temperature information falls within the reference temperature range; and
(b23) computing, by the heat dissipation information computation unit, the heat dissipation information so that the fan member stops, if the temperature information is out of the reference temperature range.

17. The control method for a cooling device of claim 14,
wherein the step (b3) comprises:
(b31) comparing, by the flow passage information computation unit, temperature information about the temperature of fluid flowing in a main tank space among the computed state information with a preset reference temperature range;
(b32) computing, by the flow passage information computation unit, the flow passage information so that the pump member stops, if the temperature information falls within the reference temperature range; and
(b33) computing, by the flow passage information computation unit, the flow passage information so that the pump member stops, if the temperature information is out of the reference temperature range.

18. The control method for a cooling device of claim 17,
wherein the step (b33) comprises:
(b331) receiving, by the flow passage information computation unit, the computed cooling information;
(b332) computing, by the flow passage information computation unit, timing information about timing when the thermoelectric element is operated among the content of the computed cooling information; and
(b333) computing, by the flow passage information computation unit, the flow passage information so that the pump member operates after a preset time has elapsed from the computed timing information.

19. The control method for a cooling device of claim 17,
wherein the step (b33) comprises:
(b334) receiving, by the flow passage information computation unit, the computed heat dissipation information;
(b335) computing, by the flow passage information computation unit, timing information about timing when the fan member is operated among the content of the computed cooling information; and
(b336) computing, by the flow passage information computation unit, the flow passage information so that the pump member operates after a preset time has elapsed from the computed timing information.

20. The control method for a cooling device of claim 12,
wherein the step (c) comprises:
(c1) controlling, by a heat exchanger control module, the operation of a thermoelectric element of the heat exchanger according to cooling information among the computed operation information;
(c2) controlling, by the heat exchanger control module, the operation of a fan member of the heat exchanger according to heat dissipation information among the computed operation information; and
(c3) controlling, by a pump member control module, the operation of a pump member of the sub-tank according to flow passage information among the computed operation information.
